# EUROPÄISCHE PATENTSCHRIFT

(11) **EP 0 839 341 B1**
(45) Veröffentlichungstag und Bekanntmachung des Hinweises auf die Patenterteilung: **25.09.2002**
(21) Anmeldenummer: 96925684.1
(22) Anmeldetag: 08.07.1996
(51) Int. Cl.: G03F 7/031

(54) **HETEROGENE PHOTOINITIATOREN, PHOTOPOLYMERISIERBARE ZUSAMMENSETZUNGEN UND DEREN VERWENDUNG**
HETEROGENEOUS PHOTO-INITIATORS, PHOTOPOLYMERISABLE COMPOSITIONS AND THEIR USE
PHOTOAMORCEURS HETEROGENES, COMPOSITIONS PHOTOPOLYMERISABLES ET LEUR UTILISATION

(30) Priorität: 19.07.1995 CH 213095
(43) Veröffentlichungstag der Anmeldung: 06.05.1998
(73) Patentinhaber: Ciba Specialty Chemicals Holding Inc., 4057 Basel (CH)
(72) Erfinder: ELDIN, Sameer, Hosam, CH-1784 Courtepin (CH); GRIESHABER, Peter, CH-1719 Zumholz (CH); RIME, François, CH-1723 Marly 2 (CH); DIETLIKER, Kurt, CH-1700 Fribourg (CH)
(86) Internationale Anmeldenummer: EP9602988
(87) Internationale Veröffentlichungsnummer: WO97004361

(56) Entgegenhaltungen:
- EP-A- 0 217 205
- EP-A- 0 281 941
- WO-A-95/10552
- US-A- 5 100 987
- ACS SYMPOSIUM SERIES, RADIATION CURING OF POLYMERIC MATERIALS, Bd. 417, WASHINGTON, DC, US, XP002018713 M KÖHLER ET AL: "Coreactive Photoinitiators for Surface Polymerization" in der Anmeldung erwähnt

## Beschreibung

Die vorliegende Erfindung betrifft ein Trägermaterial in Form von Mikropartikeln mit kovalent gebundenen gleichen oder verschiedenen Photoinitiatoren; eine Zusammensetzung aus wenigstens einem photopolymerisierbaren oder photovernetzbaren Monomer und dem Trägermaterial; Polymere aus diesen Zusammensetzungen; ein mit der Zusammensetzung beschichtetes Substrat; ein Substrat mit einer Schutzschicht oder einer Reliefabbildung aus der polymerisierten Zusammensetzung; ein Verfahren zur Photopolymerisation von Monomeren; und die Verwendung des Trägermaterials als Photoinitiatoren.

N. Sasa et al. beschreiben in Polymers for Advanced Technologies, Volume 5, Seiten 98 bis 104 (1994) UV-sensitive photopolymerisierbare Systeme, die neben dem photopolymerisierbaren Monomeren und dem darin gelösten Photoinitiator ein ionogenes vernetztes Mikrogel enthalten. Die Lichtempfindlichkeit dieser Systeme wird als höher angegeben im Vergleich zu homogenen Systemen ohne Mikrogel. Die Systeme können zur lithographischen Herstellung von Druckplatten verwendet werden.

In Polymers for Advanced Technologies, Volume 5, Seiten 297 bis 308 (1994) erwähnen N. Sasa et al., dass die Lichtempfindlichkeit dieser Systeme weiter gesteigert werden kann, wenn die Mikrogele ethylenisch ungesättigte Gruppen ionogen oder kovalent gebunden enthalten.

Diese Zusammensetzungen weisen bei der Beschichtung im Vergleich zu reinen Lösungen den Vorteil auf, dass deren Fliessfähigkeit herabgesetzt ist, so dass sie anwendungstechnisch einfacher zu handhaben sind und vor der Belichtung zum Schutz vor Verunreinigungen mit Kunststoffolien zum Beispiel aus Polyvinylalkohol abgedeckt werden können. Als Nachteil wird generell empfunden, dass der Photoinitiator in den Monomeren gelöst werden muss, wie dies auch bei makromolekularen Photoinitiatoren der Fall ist. Solche Photoinitiatoren sind zum Beispiel von K. K. Dietliker in Chemistry & Technology of UV & EB Formulation for Coatings, Inks and Paints, Volume 3: Photoinitiators for Free Radical and Cationic Polymerisation, 1991 (Published by SITA Technology Ltd, London), beschrieben.

M. Köhler et al. beschreiben in Radiation Curing of Polymeric Materials; Hoyle, C. E., Kinstle J. F., Editors; American Chemical Society: Washington, D.C., Seiten 106 bis 124 (1990), dass man funktionalisierte α-Hydroxyacetophenone auf käuflichem Silicagel immobilisieren kann. Dieses Silicagel hat Partikelgrössen im Millimeterbereich. Bei Untersuchungen zur Photopolymerisation wurde festgestellt, dass Polymere ausschliesslich auf der Oberfläche des modifizierten Silicagels gebildet werden und keine Massepolymerisation eines vorhandenen ethylenisch ungesättigten Monomers möglich ist.
In US 5,100,987 sind polymere Photoinitiatoren, welche lineare, unvernetzte Polymerisate aus monoethylenisch ungesättigten Monomeren enthalten, offenbart.

Es wurde nun überraschend gefunden, dass man das Lösen der Photoinitiatoren gänzlich vermeiden kann und Photoinitiatoren in heterogener Form verwenden kann, wenn sie als Mikropartikel mit kovalent gebundenen Photoinitiatoren eingesetzt werden. Es wurde ferner überraschend gefunden, dass diese heterogenen Photoinitiatoren eine ausgezeichnete Lichtempfindlichkeit aufweisen, die in der Regel sogar höher als in den von N. Sasa beschriebenen Systemen oder Systemen mit gelösten Photoinitiatoren ist. Diese heterogenen Photoinitiatoren weisen auch betriebshygienische und und anwendungstechnische Vorteile auf, da es sich um lagerstabile, staubfreie und rieselfähige Produkte handelt, die problemlos zu photopolymerisierbaren Zusammensetzungen verarbeitet werden können, oft sogar ohne Mitverwendung eines Tensids. Die Lichtempfindlichkeit kann überraschend sogar noch weiter gesteigert werden, wenn die Mikropartikel zusätzlich ethylenisch ungesättigte Gruppen ionogen oder kovalent gebunden enthalten.

Ein erster Gegenstand der Erfindung ist daher ein heterogener Photoinitiator in Form von Mikropartikeln mit einer mittleren Teilchengrösse von 2 bis 1000 nm, der aus einem feinteiligen Trägermaterial besteht, an das gleiche oder verschiedene Photoinitiatoren kovalent gebunden sind und bei dem es sich um ein Polymerisat handelt, an dessen Rückgrat monovalente Reste der Photoinitiatoren direkt oder über eine Brückengruppe kovalent gebunden sind, wobei das Polymerisat mindestens ein Strukturelement der Formel XI enthält, 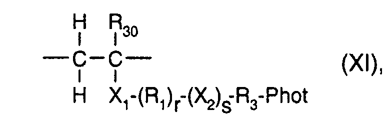 worin
R₃₀ H oder Methyl bedeutet,
X₁ und X₂ unabhängig voneinander eine direkte Bindung, oder X₂ und X₁ zusammen unabhängig voneinander -O-, -S-, -NR₂-, -C(O)-O-, -O-C(O)-, -O-C(O)-O-, -SO₂-O-, -O-SO₂-, -O-SO₂-O-, -NR₂-C(O)-, -C(O)-NR₂-, -NR₂-C(O)-O-, O-C(O)-NR₂-, -NR₂-C(O)-NR₂-, -NR₂-SO₂-, -SO₂-NR₂-, -NR₂-SO₂-O-, O-SO₂-NR₂- oder -NR₂-SO₂-NR₂- bedeuten,
R₁ eine bivalente Brückengruppe darstellt,
Phot für einen monovalenten Rest eines Photoinitiators steht,
R₃ eine direkte Bindung, C₁-C₁₈-Alkylen, C₅- oder C₆-Cycloalkylen, C₆-C₁₀-Arylen oder C₇-C₁₂-Aralkylen bedeutet,
r die Zahlen 0 oder 1 und s die Zahlen 0 oder 1 bedeuten, sowie s für die Zahl 0 steht, wenn r die Zahl 0 darstellt, und
das Polymerisat mit gleichen oder verschiedenen Strukturelementen der Formeln XIV oder XV vernetzt ist, 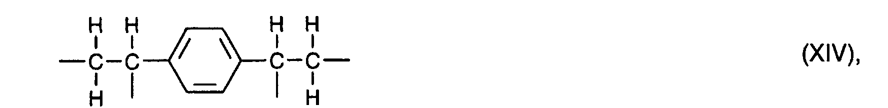 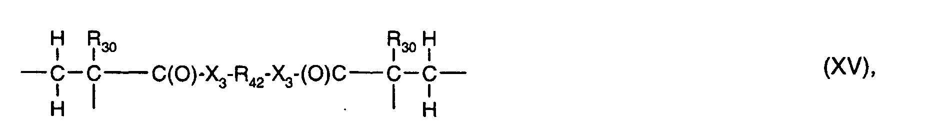 worin
R₃₀ H oder Methyl bedeutet,
X₃ für -O- oder -NH- oder -N(C₁-C₄-Alkyl)- steht und
R₄₂ C₂-C₁₂- und bevorzugt C₁-C₆-Alkylen, Cyclohexylen, Cyclohexylendimethylen oder X₃ für -O- steht und R₄₂ C₂-C₆-Alkylen-(C₂-C₆-Alkylen-O)_{2 bis 20}- C₂-C₆-Alkylen-darstellt.

Heterogen bedeutet im Rahmen der Erfindung, dass die Photoinitiatoren in den photopolymerisierbaren beziehungsweise photovernetzbaren Zusammensetzungen unlöslich oder nur quellbar sind. Quellbare feinteilige Trägermaterialien werden auch als Mikrogele oder Emulsionspolymerisate (Latex) bezeichnet, und sind im Rahmen der vorliegenden Erfindung bevorzugt.

Mikropartikel bedeutet im Rahmen der Erfindung eine mittlere Teilchengrösse von bevorzugt 2 bis 1000 nm, bevorzugter 5 bis 500 nm, noch bevorzugter 5 bis 300 nm, besonders bevorzugt 5 bis 200 nm, und insbesondere bevorzugt 5 bis 100 nm. Die Teilchen können eine runde oder irreguläre Gestalt aufweisen, je nach ihren Herstellungsverfahren.

Bei den Photoinitiatoren kann man zwei Ausführungsformen unterscheiden, nämlich (A) Polymere aus Monomeren mit kovalent gebundenen Photoinitiatoren und gebenenenfalls Comonomeren, und (B) nachträglich auf der Oberfläche modifizierte anorganische oder organische Trägermaterialien mit kovalent gebundenen Photoinitiatoren und gegebenenfalls kovalent gebundenen Sensibilisatoren, Coinitiatoren oder polymerisierbaren Gruppen. Die nachfolgenden Angaben beziehen sich auf die Ausführungsform (A), die gegenüber den Polymeren der Ausführungsform (B) den Vorteil eines geringeren Verbrauchs an Photoinitiator bietet, da dieser nicht teilweise in den Mikropartikeln einpolymerisiert ist.

Bei dem Trägermaterial kann es sich um anorganische oder organische Trägermaterialien handeln. Das Trägermaterial kann opak, transluszent oder transparent sein. Bevorzugt sind transparente Trägermaterialien. Opake beziehungsweise transluszente Trägermaterialien können zum Beispiel bei der Herstellung von dünnen Schichten eingesetzt werden. Geeignete Trägermaterialien sind zum Beispiel Kunststoffe, Glas, Keramiken, Mineralien, Gesteine, Metalloxide, Metallnitride, Metallcarbide, Metalle und Metallegierungen. Die Trägermaterialien enthalten zur Bindung der Photoinitiatoren funktionelle Gruppen, die - falls erforderlich - in einfacher Weie durch Plasmabehandlung gegebenenfalls in einer reaktiven Gasatmosphäre erzeugt werden können. Bevorzugte Trägermaterialien sind Kunststoffe, zum Beispiel Polymere mit funktionellen Gruppen oder nachträglich oberflächen-modifizierte Polymere zur Einführung von funktionellen Gruppen für die kovalente Bindung der Photoinitiatoren.

Bei den funktionellen Gruppen handelt es sich im Fall der anorganischen Trägermaterialien bevorzugt um Amin-, und besonders bevorzugt um Hydroxylgruppen. Diese funktionellen Gruppen werden im allgemeinen mit Ankergruppen versehen, an die die Photoinitiatoren direkt oder über eine Brückengruppe gebunden sind. Bevorzugt sind für diesen Zweck Silane mit einer funktionellen Gruppe, zum Beispiel Tri-(C₁-C₄-alkoxy)Si-(CH₂)ₚ-NH₂, Tri-(C₁-C₄-alkoxy)Si-(CH₂)ₚ-OH, Tri-(C₁-C₄-alkoxy)Si-(CH₂)ₚ-NH-CH₂CH₂-NH₂, Tri-(C₁-C₄-alkoxy)Si-(CH₂)ₚ-C(O)OH, Tri-(C₁-C₄-alkoxy)-(prop-1-en-3-yl)silan, Tri-(C₁-C₄-alkoxy)-glycidoxysilan oder Tri-(C₁-C₄-alkoxy)Si-(CH₂)ₚ-NCO, wobei p für eine Zahl von 2 bis 12, bevorzugt 2 bis 6 und besonders bevorzugt 2 bis 4 steht. Einige Beispiele sind γ-Aminopropyl-trimethoxy- oder -triethoxysilan, γ-Hydroxyropyl-trimethoxy- oder -triethoxysilan und 2-Trimethoxy- oder 2-Triethoxysilylpropionsäure.

Bei den funktionellen Gruppen handelt es sich im Fall der organischen Trägermaterialien bevorzugt um Amin-, Hydroxyl-, Carboxyl-, -SO₃H oder Isocyanatgruppen. Es kann sich um nachträglich modifizierte (zum Beispiel mittels Plasmabehandlung) oder gemahlene natürliche oder synthetische Polymere mit funktionellen Gruppen handeln. Als synthetische Polymere kommen auch Emulsionspolymere und Latices aus wenigstens einem Monomeren mit funktionellen Gruppen in Frage. Beispiele für natürliche Polymere sind Polysacharide wie Cellulose, Stärke, Carragenan oder Chitosan, die teilweise mit C₁-C₄-Alkyl verethert oder mit C₁-C₈-Acyl acyliert sein können. Synthetische Polymere mit funktionellen Gruppen sind in grosser Vielzahl bekannt oder können nach analogen Verfahren hergestellt werden. Einige Beispiele für synthetische Polymere sind Polyvinylalkohol und Copolymere mit unsubstituierten oder substituierten Olefinen als Comonomeren; Polymethacrylsäure, Polyacrylsäure und Polymaleinsäure und Copolymere mit unsubstituierten oder substituierten Olefinen als Comonomeren; Polyhydroxyalkylacrylate, Polyhydroxyalkylmethacrylate und Polymaleinsäurehydroxyalkylester und Copolymere mit unsubstituierten oder substituierten Olefinen als Comonomeren; Polyacrylamide und Polymethacrylamide und Copolymere mit unsubstituierten oder substituierten Olefinen als Comonomeren; Polyaminoalkylacrylsäureester, methacrylsäurester und maleinsäureester und Copolymere mit unsubstituierten oder substituierten Olefinen als Comonomeren; Polyhydroxyalkyl- oder Polyaminoalkylvinylalkohol und Copolymere mit unsubstituierten oder substituierten Olefinen als Comonomeren; hydroxylierte Polybutadiene aus Butadien, Isopren oder Chloropren und Copolymere mit unsubstituierten oder substituierten Olefinen als Comonomeren; Hydroxy- oder Aminopolystyrol, Chlormethypolystyrol, und Polystyrolsulfonsäure und Copolymere mit unsubstituierten oder substituierten Olefinen als Comonomeren; Polyglycidylether und hydroxyalkylierte oder aminoalkylierte Polyglycidylether; und Polyester, Polyamide und Polyurethane mit hydroxylgruppenhaltigen Monomeren. Femer kommen auch Duroplaste in Frage, zum Beispiel Epoxidharze, Melamin-Formaldehyd-Harze und Phenol-Formaldehyd-Harze. Geeignete Comonomere sind zum Beispiel Olefine wie Ethen, Propen, Buten, Penten, Octen; Vinylchlorid, Vinylidenchlorid; Styrol; und Acrylnitril. Ferner kommen vernetzte Polymere in Betracht, zum Beispiel Polymerisate mit Olefinen und diolefinischen Monomeren wie Butadien, Divinylbenzol oder Dioldiacryl- oder -methacrylsäurester. Weitere geeignete Vinylpolymere sind Polyvinylpyrrolidon, Polyvinylimidazol und Polyvinylpyridin und Copolymere mit unsubstituierten oder substituierten Olefinen als Comonomeren.

Der Photoinitiator wird zweckmässig über eine Brückengruppe kovalent an das Trägermaterial gebunden. Die Brückengruppe kann 1 bis 30 Atome, bevorzugt 1 bis 20 Atome und besonders bevorzugt 1 bis 12 Atome ausgewählt aus der Gruppe C, O, S und N enthalten. Bei der Brückengruppe handelt es sich bevorzugt um Kohlenwasserstoffreste, die mit einem oder mehreren Heteroatomen aus der Gruppe O, S und N unterbrochen sein können.

Der an die funktionellen Gruppen an der Oberfläche gebundene Rest eines Photoinitiators kann zum Beispiel der Formel I entsprechen,

-X₁-(R₁)ᵣ-(X₂)ₛ-R₃-Phot (I),

worin
X₁ und X₂ unabhängig voneinander eine direkte Bindung, oder X₂ und X₁ unabhängig voneinander -O-, -S-, -NR₂-, -C(O)-O-, -O-C(O)-, -O-C(O)-O-, --SO₂-O-, -O-SO₂-, -O-SO₂-O-, -NR₂-C(O)-, -C(O)-NR₂-, -NR₂-C(O)-O-, O-C(O)-NR₂-, NR₂-C(O)-NR₂-, -NR₂-SO₂-, -SO₂-NR₂-, -NR₂-SO₂-O-, O-SO₂-NR₂- oder -NR₂-SO₂-NR₂- bedeuten,
R₁ eine bivalente Brückengruppe darstellt,
Phot für einen monovalenten Rest eines Photoinitiators steht,
R₂ H, C₁-C₁₂-Alkyl, C₅- oder C₆-Cycloalkyl, C₅- oder C₆-Cycloalkylmethyl oder -ethyl, Phenyl, Benzyl oder 1-Phenyleth-2-yl steht,
R₃ eine direkte Bindung, C₁-C₁₈-Alkylen, C₅- oder C₆-Cycloalkylen, C₆-C₁₀-Arylen oder C₇-C₁₂-Aralkylen bedeutet,
r die Zahlen 0 oder 1 und s die Zahlen 0 oder 1 bedeuten, und s für 0 steht, wenn r 0 darstellt.

R₂ in der Bedeutung von Alkyl enthält bevorzugt 1 bis 6 und besonders bevorzugt 1 bis 4 C-Atome. Einige Beispiele sind Methyl, Ethyl, n- oder i-Propyl, Butyl Hexyl und Octyl. R₂ in der Bedeutung von Cycloalkyl ist bevorzugt Cyclohexyl, und in der Bedeutung von Cycloalkylmethyl Cyclohexylmethyl. In einer bevorzugten Ausführungsform stellt R₂ H oder C₁-C₄-Alkyl dar.

Die bivalente Brückengruppe R₁ stellt bevorzugt einen Kohlenwasserstoffrest dar, der bevorzugt 1 bis 30, bevorzugter 1 bis 18, besonders bevorzugt 1 bis 12 und besonders bevorzugt 1 bis 8 C-Atome enthält, der unsubstituiert oder mit C₁-C₄-Alkyl, C₁-C₄-Alkoxy oder =O ein- oder mehrfach substituiert ist. Der Kohlenwasserstoffrest kann auch ein- oder mehrfach mit Heteroatomen ausgewählt aus der Gruppe -O-, -S- und -NR₂- unterbrochen sein, wobei R₂ bevorzugt H oder C₁-C₄-Alkyl darstellt.

Bei der bivalenten Brückengruppe kann es sich zum Beispiel um C₁-C₂₀-, bevorzugt C₂-C₁₂-Alkylen handeln, das linear oder verzweigt sein kann. Einige Beispiele sind Methylen, Ethylen, 1,2- oder 1,3-Propylen, 1,2-, 1,3- oder 1,4-Butylen, Pentylen, Hexylen, Octylen, Dodecylen, Tetradecylen, Hexadecylen und Octadecylen.

Bei der bivalenten Brückengruppe kann es sich zum Beispiel um Polyoxaalkylen mit 2 bis 12, bevorzugt 2-6 und besonders bevorzugt 2 bis 4 Oxaalkyleneinheiten und und 2 bis 4, bevorzugt 2 oder 3 C-Atomen im Alkylen. Besonders bevorzugt handelt es sich um Polyoxaethylen und Polyoxapropylen mit 2 bis 6 Oxaalkyleneinheiten.

Bei der bivalenten Brückengruppe kann es sich zum Beispiel um C₅-C₁₂-, bevorzugt C₅-C₈ - und besonders bevorzugt um C₅- oder C₆-Cycloalkyl wie zum Beispiel Cyclopentylen, Cyclohexylen, Cyclooctylen oder Cyclododecylen handeln.

Bei der bivalenten Brückengruppe kann es sich zum Beispiel um C₅-C₁₂-, bevorzugt C₅-C₈ - und besonders bevorzugt um C₅- oder C₆-Cycloalkyl-C₁-C₁₂- und bevorzugt -C₁-C₄-alkyl handeln. Einige Beispiele sind Cyclopentyl-CₙH₂ₙ- und Cyclohexyl-CₙH₂ₙ-, worin n für eine Zahl von 1 bis 4 steht. Besonders bevorzugt ist -Cyclohexyl-CH₂-.

Bei der bivalenten Brückengruppe kann es sich zum Beispiel um C₅-C₁₂-, bevorzugt C₅-C₈ - und besonders bevorzugt um C₅- oder C₆-Cycloalkyl-(C₁-C₁₂-Alkyl)₂- und bevorzugt (-C₁-C₄-alkyl)₂ handeln. Einige Beispiele sind Cyclopentyl-(CₙH₂ₙ-)₂ und Cyclohexyl-(CₙH₂ₙ-)₂, worin n für eine Zahl von 1 bis 4 steht. Besonders bevorzugt ist -CH₂-Cyclohexyl-CH₂-.

Bei der bivalenten Brückengruppe kann es sich zum Beispiel um C₆-C₁₄-Arylen und bevorzugt C₆-C₁₀-Arylen handeln, zum Beispiel um Naphtylen oder bevorzugter um Phenylen.

Bei der bivalenten Brückengruppe kann es sich zum Beispiel um C₇-C₂₀-Aralkylen und bevorzugt um C₇-C₁₂-Aralkylen handeln. Bevorzugter ist Arylen-CₙH₂ₙ-, worin Arylen für Naphthylen und besonders Phenylen und n für eine Zahl von 1 bis 4 steht. Beispiele sind Benzylen und Phenylethylen.

Bei der bivalenten Brückengruppe kann es sich zum Beispiel um Arylen-(CₙH₂ₙ-)₂- handeln, worin Arylen bevorzugt Naphtylen und besonders Phenylen ist und n für eine Zahl von 1 bis 4 steht. Beispiele sind Xylylen und Phenylen(CH₂CH₂)₂-.

R₃ enthält als Alkylen bevorzugt 1 bis 12 und besonders bevorzugt 1 bis 6 C-Atome. Besonders bevorzugte Beispiele sind Methylen, Etylen, 1,2- oder 1,3-Propylen und 1,2-, 1,3- und 1,4-Butylen. R₃ ist als Arylen bevorzugt Phenylen und als Aralkylen Benzylen.

Monomere und polymere Photoinitiatoren sind in grosser Vielzahl bekannt geworden und zum Beispiel von K. K. Dietliker in Chemistry & Technology of UV & EB Formulation for Coatings, Inks and Paints, Volume 3: Photoinitiators for Free Radical and Cationic Polymerisation, 1991 (Published by SITA Technology Ltd, London), oder von C. G. Roffey, Photopolymerisation of Surface Coatings, John Wiley & Sons, 1985 beschrieben. Es kann sich um radikalische oder kationische Photoinitiatoren handeln. Die Photoinitiatoren können alleine oder zusammen mit Sensibilisatoren beziehungsweise Coinitiatoren verwendet werden, welche im photopolymerisierbaren System gelöst oder an das Trägermaterial kovalent gebunden sein können.

Bei den Photoinitiatoren, von denen sich der Rest der Formel I ableitet, kann es sich zum Beispiel um Benzoin, Hydroxybenzoin, und hydroxyalkylierte Benzoinderivate handeln. Sie können der Formel II entsprechen, 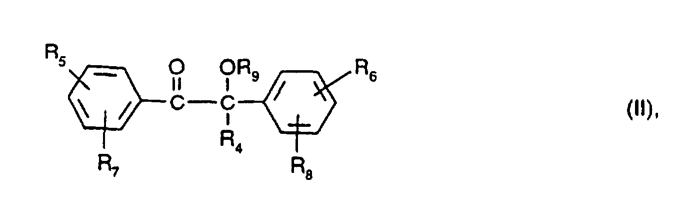 worin
R₄ H, C₁-C₈-Alkyl, C₁-C₆-Hydroxyalkyl, Cyclohexyl, Phenyl oder Benzyl darstellt, R₉ H, C₁-C₈-Alkyl, C₂-C₆-Hydroxalkyl oder C₁-C₆-Carboxylalkyl bedeutet, und R₅, R₆, R₇ und R₈ unabhängig voneinander H, C₁-C₄-Alkyl, C₁-C₄-Alkoxy, F oder Cl darstellen; oder
R₄ C₁-C₆-Hydroxyalkyl oder C₁-C₆-Carboxylalkyl bedeutet, R₉ C₁-C₈-Alkyl, Cyclohexyl, Phenyl oder Benzyl darstellt, und R₅, R₆, R₇ und R₈ unabhängig voneinander H, C₁-C₄-Alkyl, C₁-C₄-Alkoxy, F oder Cl darstellen; oder
eines von R₅, R₆, R₇ und R₈ Hydroxyl und die anderen H, C₁-C₄-Alkyl, C₁-C₄-Alkoxy, F oder Cl darstellen, R₄ H, C₁-C₄-Alkoxy, Benzyloxy oder Phenyloxy bedeuten, und R₉ H, C₁-C₆-Alkyl, C₂-C₆Hydroxyalkyl, Cyclohexyl, Phenyl oder Benzyl darstellt.

R₄ und R₉ enthalten als Alkyl bevorzugt 1 bis 6 und besonders bevorzugt 1 bis 4 C-Atome. Einige Beispiele sind Methyl, Ethyl, n- und i-Propyl. n-, i- und t-Butyl. R₄ enthält als Hydroxyalkyl bevorzugt 1 bis 4 C-Atome und stellt besonders Hydroxymethyl dar. R₉ enthält als Hydroxyalkyl bevorzugt 1 bis 4 C-Atome und stellt zum Beispiel 2-Hydroxyeth-1-yl, 2-Hydroxyprop-1-yl, 3-Hydroxyprop-1-yl, 2-Hydroxybut-1-yl oder 4-Hydroxybut-1-yl dar. Beispiele für Carboxylalkyl sind Carboxylmethyl, Carboxylethyl und Carboxylpropyl. R₅, R₆, R₇ und R₈ sind bevorzugt H.

Einige Beispiele sind neben Benzoin 4-Hydroxybenzoin, Benzoinhydroxyethylether, Methylolbenzoin, Methylolbenzoinmethyl-, -ethyl- oder -propylether, und Carboxylethylbenzoinmethyl-, -ethyl- oder -propylether.

Bei den Photoinitiatoren, von denen sich der Rest der Formel I ableitet, kann es sich zum Beispiel um α-Hydroxyalkylphenone handeln. Sie können der Formel III entsprechen, 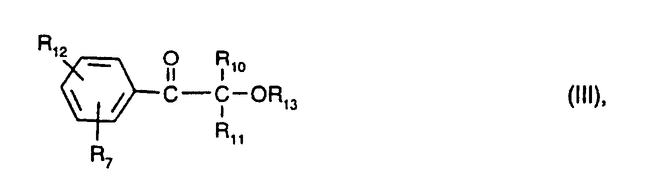 worin
R₇ H, C₁-C₄-Alkyl, C₁-C₄-Alkoxy, F, oder CI darstellt;
R₁₀ und R₁₁ unabhängig voneinander C₁-C₁₂-, bevorzugt C₁-C₈- und besonders bevorzugt C₁-C₄-Alkyl, C₅- oder C₆-Cycloalkyl, Phenyl oder Phenyl-C₁-C₄-Alkyl bedeuten, oder R₁₀ und
R₁₁ zusammen -CₙH₂ₙ- darstellen und n für eine Zahl von 3 bis 7, bevorzugt 4 oder 5 steht;
R₁₂ H, -OH, -SH, C₂-C₆-Hydroxyalkyloxy oder C₂-C₆-Hydroxyalkylthio bedeutet; und
R₁₃ H, C₁-C₆-Alkyl, C₅- oder C₆-Cycloalkyl, Phenyl oder Benzyl darstellt,
mit der Massgabe, dass R₁₂ nicht H ist, wenn R₁₃ H, C₁-C₆-Alkyl, C₅- oder C₆-Cycloalkyl, Phenyl oder Benzyl darstellt.

Beispiele für Hydroxyalkylphenone sind 2-Hydroxy-2-methyl-1-phenyl-propanon, 2-Hydroxy-2-methyl-1-(4'-i-propylphenyl)-propanon, 2-Hydroxy-2-methyl-1-(4'-hydroxyphenyl)-propanon, 2-Hydroxy-2-methyl-1-(4'-i-propylphenyl)-propanon, 2-Hydroxy-2-methyl-1-(4'-hydroxyethoxyylphenyl)-propanon und 1-Hydroxycyclohexylphenylketon.

Andere geeignete Photoinitiatoren, von denen sich der Rest der Formel I ableitet, sind zum Beispiel Hydroxylgruppen enthaltende Benzilketale, die der Formel IV entsprechen können, 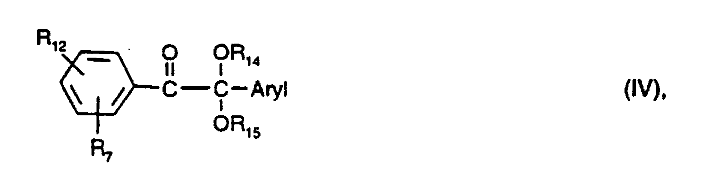 worin
R₇ H, C₁-C₄-Alkyl, C₁-C₄-Alkoxy, F oder Cl darstellt;
R₁₂ -OH, -SH, C₂-C₆-Hydroxyalkyloxy oder C₂-C₆-Hydroxyalkylthio bedeutet;
R₁₄ und R₁₅ unabhängig voneinander C₁-C₆-Alkyl, C₅- oder C₆-Cycloalkyl, Phenyl oder Phenyl-C₁-C₄-Alkyl bedeuten;
R₁₄ und R₁₅ zusammen für C₂-C₄-Alkylen oder C₂-C₄-Alkenylen stehen, und
Aryl für unsubstituiertes oder mit C₁-C₄-Alkyl, C₁-C₄-Alkoxy, F oder Cl substituertes Naphthyl und besonders Phenyl steht.

Einige Beispiele für solche Benzilketale sind 2,2-Dimethoxy-2-phenyl-hydroxy- oder -mercaptol-acetophenon, 2,2-Dimethoxy-2-phenyl-hydroxyethoxy- oder -hydroxyethylthio-acetophenon, 2,2-Diethoxy-2-phenyl-hydroxy- oder -mercaptol-acetophenon, 2,2-Diethoxy-2-phenyl-hydroxyethoxy- oder -hydroxyethylthio-acetophenon und 2-Hydroxybenzoyl-2-phenyl-1,3-dioxalan.

Weitere geeignete Photoinitiatoren, von denen sich der Rest der Formel I ableitet, sind zum Beispiel Hydroxylgruppen, Thiolgruppen oder -NHR₂-Gruppen enthaltende α-Aminoalkylphenone, die der Formel V entsprechen können, 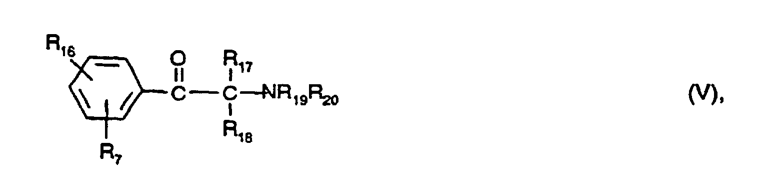 worin
R₇ H, C₁-C₄-Alkyl, C₁-C₄-Alkoxy, F oder Cl darstellt;
R₁₆ -OH, -SH, -NHR₂, C₂-C₆-Hydroxyalkyloxy oder C₂-C₆-Hydroxyalkylthio oder C₂-C₆-Hydroxyalkyl-NR₂- bedeutet, und R₂ H, C₁-C₁₂-Alkyl, C₅- oder C₆-Cycloalkyl. C₅- oder C₆-Cycloalkylmethyl oder -ethyl, Phenyl, Benzyl oder 1-Phenyleth-2-yl ist;
R₁₇ und R₁₈ unabhängig voneinander C₁-C₁₂-Alkyl, C₅- oder C₆-Cycloalkyl, C₅- oder C₆-Cycloalkylmethyl oder-ethyl, Phenyl, Phenylmethyl oder 1-Penyleth-2-yl darstellen, wobei die Phenylgruppen unsubstituiert oder mit C₁-C₄-Alkyl oder C₁-C₄-Alkoxy substituiert sind; und
R₁₉ und R₂₀ unabhängig voneinander C₁-C₁₂-Alkyl, C₂-C₆-Alkenyl, C₂-C₆-Hydroxyalkyl, C₅ - oder C₆-Cycloalkyl, C₅- oder C₆-Cycloalkylmethyl oder -ethyl, Phenyl, Phenylmethyl oder 1-Penyleth-2-yl, wobei die Phenylgruppen unsubstituiert oder mit C₁-C₄-Alkyl oder C₁-C₄-Alkoxy substituiert sind, oder R₁₉ und R₂₀ zusammen -(CH₂)₄-, -(CH₂)₅-, -CH₂CH₂-O-CH₂CH₂- oder -CH₂CH₂-NR₂-CH₂CH₂- bedeuten; und
R₂ H, C₁-C₁₂-Alkyl, C₂-C₆-Hydroxyalkyl, C₅- oder C₆-Cycloalkyl, C₅- oder C₆-Cycloalkylmethyl oder -ethyl, Phenyl, Benzyl oder 1-Phenyleth-2-yl steht.

Einige Beispiele für solche α-Aminoalkylphenone sind 2-Methyl-1-[4-hydroxyphenyl]-2-dimethylamino-propan-2-on, 2-Methyl-1-[4-thiolphenyl]-2-dimethylamino-propan-2-on, 2-Methyl-1-[4-aminophenyl]-2-dimethylamino-propan-2-on, 2-Methyl-1-[4-hydroxyphenyl]-2-morpholino-propan-2-on, 2-Methyl-1-[4-thiophenyl]-2-morpholino-propan-2-on, Methyl-1-[4-aminophenyl]-2-morpholino-propan-2-on, 2-Methyl-1-[4-(hydroxyethoxy)phenyl]-2-dimethylamino-propan-2-on, 2-Methyl-1-[4-(hydroxyethylthio)phenyl]-2-dimethylamino-propan-2-on, 2-Methyl-1-[4-(hydroxyethylamino)phenyl]-2-dimethylamino-propan-2-on, 2-Methyl-1-[4-(hydroxyethoxy)phenyl]-2-morpholino-propan-2-on, 2-Methyl-1-[4-(hydroxyethylthiophenyl]-2-morpholino-propan-2-on und Methyl-1-[4-(hydroxyethylamino)phenyl]-2-morpholino-propan-2-on.

Andere geeignete radikalische Photoinitiatoren mit funktionellen Gruppen können ausgewählt sein aus der Gruppe der Acylphosphinoxide, α-Hydroxyliminketone, organischen Peroxo-Verbindungen, halogenierten Acetophenone, Phenylglyoxylate , Thioxanthone, Xanthone, Anthrachinone, Naphthacenchinone und α-Arylthioacetophenone. Ferner können auch kationische Photoinitiatoren wie zum Beispiel photochemisch deblockierbare Lewis-Säuren und Oniumsalze mit funktionellen Gruppen zur kovalenten Bindung an Trägermaterialien verwendet werden.

Die Menge der an das Trägermaterial kovalent gebundenen Photoinitiatoren kann zum Beispiel 0,0001 bis 100, bevorzugt 0,1 bis 100, bevorzugter 1 bis 90, besonders bevorzugt 2 bis 80 und insbesondere bevorzugt 20 bis 80 Gew.-% betragen, bezogen auf das Trägermaterial.

Zur Steigerung der Lichtempfindlichkeit werden Photoinitiatoren oft in Kombination mit anderen Initiatoren oder zusammen mit Sensibilisatoren eingesetzt.

Photoinitiatoren können zur Erhöhung der Empfindlichkeit zusammen mit Sensibilisatoren oder Coinitiatoren verwendet werden. In einer bevorzugten Ausführungsform der Erfindung sind die Sensibilisatoren und Coinitiatoren über funktionelle Gruppen kovalent an das Trägermaterial gebunden. Bekannte Sensibilisatoren und Coinitiatoren sind zum Beispiel Xanthone, Anthrachinone, Naphthacenchinone, Thioxanthone, Ethanolamine, Aminobenzoesäuren und Michler's Keton. Solche funktionalisierte Sensibilisatoren und Coinitiatoren sind in grosser Zahl bekannt und werden daher hier nicht näher ausgeführt. Für die Immobilisierung kommen die zuvor beschriebenen Brückengruppen und funktionelle Gruppen in Frage.

Die Menge der kovalent gebundenen Sensibilisatoren oder Coinitiatoren kann zum Beispiel 0,0001 bis 99,9999, bevorzugt 0,1 bis 100, bevorzugter 1 bis 90, besonders bevorzugt 2 bis 80 und insbesondere bevorzugt 20 bis 80 Gew.-% betragen, bezogen auf das Trägermaterial.

In einer bevorzugten Ausführungsform sind an das Trägermaterial zusätzlich radikalisch oder kationisch photopolymerisierbare organische Verbindungen ionogen oder kovalent gebunden, die vorzugsweise den in der polymerisierbaren Zusammensetzung verwendeten Art an organischen Verbindungen entsprechen. In radikalisch polymerisierbaren ethylenisch ungesättigten System verwendet man demnach vorteilhaft ethylenisch ungesätigte Verbindungen mit funktionellen Gruppen, und in kationisch polymerisierbaren Systemen wie zum Beispiel Di- oder Polyepoxiden zweckmässig Di- oder Polyepoxide mit funktionellen Gruppen.

Bevorzugt werden ethylenisch ungesätigte organische Verbindungen mit funktionellen Gruppen, die in grosser Zahl bekannt sind. Die an das Trägermaterial kovalent gebundenen Reste ethylenisch ungesättigten organischen Verbindungen können zum Beispiel der Formel VI entsprechen,

-X₁-(R₁)ᵣ-(X₂)ₛ-R₃-CR₂₁=CHR₂₂ (VI),

worin
X₁ und X₂ unabhängig voneinander eine direkte Bindung, oder X₂ und X₁ zusammen mit der funktionellen Gruppe unabhängig voneinander -O-, -S-, -NR₂-, -C(O)-O-, -O-C(O)-, -O-C(O)-O-, --SO₂-O-, -O-SO₂-, -O-SO₂-O-, -NR₂-C(O)-, -C(O)-NR₂-, -NR₂-C(O)-O-, O-C(O)-NR₂-, -NR₂-C(O)-NR₂-, -NR₂-SO₂-, -SO₂-NR₂-, -NR₂-SO₂-O-, O-SO₂-NR₂- oder -NR₂-SO₂-NR₂- bedeuten,
R₁ eine bivalente Brückengruppe darstellt,
R₂ H, C₁-C₁₂-Alkyl, C₅- oder C₆-Cycloalkyl, C₅- oder C₆-Cycloalkylmethyl oder -ethyl, Phenyl, Benzyl oder 1-Phenyleth-2-yl steht,
R₃ eine direkte Bindung, C₁-C₁₈-Alkylen, C₅- oder C₆-Cycloalkylen, C₆-C₁₀-Arylen oder C₇-C₁₂-Aralkylen bedeutet,
r die Zahlen 0 oder 1 und s die Zahlen 0 oder 1 bedeuten, und s für 0 steht, wenn r 0 darstellt;
R₂₁ H oder C₁-C₄-Alkyl, besonders Methyl bedeutet; und
R₂₂ H, C₁-C₁₂-Alkyl, Phenyl oder Benzyl darstellt.

Für X₁, X₂, R₁, R₂ und R₃ gelten die bei Formel I dargestellten Bevorzugungen. R₂₁ sind bevorzugt H oder Methyl, und R₂₂ ist bevorzugt H.

Beispiele für funktionelle Gruppen enthaltende ethylenisch ungesättigte Verbindungen sind ethylenisch ungesättigte Alkohole, Amine und Isocyanate wie zum Beispiel Allylalkohol, Allylamin, Allylisocyanat, Crotonalkohol; Monoester oder Monoamide von Dicarbonsäuren und ungesättigten Alkoholen und Aminen; funktionelle Styrole wie zum Beispiel Chlormethylstyrol, Hydroxystyrol, Hydroxyethoxystyrol, Styrolamin, Styrol-hydroxyethyl-amin, Styrolcarbonsäure, Styrolsolfonsäure, Vinyl-hydroxyethyl-ether, Acrylsäure, Methacrytsäure, Acryl- und Methacrylsäureamid, Acryl- und Methacrylsäure-C₂-C₆-hydroxyalkyl-amid, Acryl- und Methacrylsäure-C₂-C₆-hydroxyalkylester.

Die Menge der ionogen oder kovalent gebundenen radikalisch oder kationisch photopolymerisierbaren organischen Verbindungen kann zum Beispiel 0,0001 bis 99,9999, bevorzugt 0,1 bis 100, bevorzugter 1 bis 90, besonders bevorzugt 2 bis 80 und insbesondere bevorzugt 20 bis 80 Gew.-% betragen, bezogen auf das Trägermaterial.

Die Gew.-% ergänzen sich stets zu 100 %.

Die Immobilisierung kann nach allgemein bekannten Verfahren durchgeführt werden. Dabei ist es grundsätzlich auch möglich, vorhandene funktionelle Gruppen in andere funktionelle Gruppen umzuwandeln, zum Beispiel -CH₂OH-Gruppen durch Oxidation in Carbonsäuren, Carbonsäuren in Amide oder Halogenide, Amingruppen in Isocyanatgruppen. Alkohole oder Amine in Carbonate oder Urethane. Ferner ist es möglich, Alkohole oder Amine zuerst mit Halogencarbonsäuren (zum Beispiel Chloressigsäure) umzusetzen. Man kann auch Kettenverlängerungsmittel wie zum Beispiel Epoxide, Azirin, Diole, Diamine, Dicarbonsäuren oder - ester und Diisocyanate ein- oder mehrfach hintereinander einsetzen, und so die Länge der Brückengruppe definiert bestimmen. Diese Methoden und Verfahren zur Immobilisierung sind bekannt und in der Fachliteratur beschrieben. Hierbei kann man die Brückengruppe ausgehend vom Trägermaterial oder von der funktionellen Verbindung aufbauen. Die anschliessende Umsetzung mit der funktionellen Verbindung beziehungsweise dem Trägermaterial führt zu den erfindungsgemässen heterogenen Photoinitiatoren. Die Reaktionen können mit üblichen inerten organischen Lösungsmitteln und bei Temperaturen von 0° C bis 200° C durchgeführt werden.

Die nachfolgenden Ausführungen beziehen sich auf die Ausführungsform (B).

Polymere Photoinitiatoren sind in grosser Vielzahl bekannt geworden und zum Beispiel von K. K. Dietliker in Chemistry & Technology of UV & EB Formulation for Coatings, Inks and Paints, Volume 3: Photoinitiators for Free Radical and Cationic Polymerisation, Seiten 204 bis 227 (1991) (Published by SITA Technology Ltd, London) beschrieben. Die makromolekularen Photoinitiatoren sind in den photopolymerisierbaren Zusammensetzungen löslich. Unlösliche heterogene Photoinitiatoren für die Massepolymerisation sind noch nicht beschrieben worden.

Die Polymeren können aus Monomereinheiten mit monovalenten Resten eines Photoinitiators und gegebenenfalls Comonomereinheiten bestehen. Der Photoinitiator kann direkt oder über eine Brückengruppe und zusätzlich Abstand gebenden Guppen an das Monomer gebunden sein. Die Brückengruppen leiten sich von an das Monomer (beziehungsweise an das Polymer) gebundenen funktionellen Gruppen ab.

Bei den funktionellen Gruppen handelt es sich im Fall der Polymeren bevorzugt um Amin-, Hydroxyl-, Carboxyl-, -SO₃H oder Isocyanatgruppen. Es kann sich um gemahlene natürliche oder synthetische Polymere mit funktionellen Gruppen handeln. Als synthetische Polymere kommen auch Emulsionspolymere und Latices aus wenigstens einem Monomeren mit funktionellen Gruppen in Frage. Beispiele für natürliche Polymere sind Polysacharide wie Cellulose, Stärke, Carragenan oder Chitosan, die teilweise mit C₁-C₄-Alkyl verethert oder mit C₁-C₈-Acyl acyliert sein können. Synthetische Polymere mit funktionellen Gruppen sind in grosser Vielzahl bekannt oder können nach analogen Verfahren hergestellt werden. Einige Beispiele für synthetische Polymere Polyvinylalkohol und Copolymere mit unsubstituierten oder substituierten Olefinen als Comonomeren; Polymethacrylsäure, Polyacrylsäure und Polymaleinsäure und Copolymere mit unsubstituierten oder substituierten Olefinen als Comonomeren; Polyhydroxyalkylacrylate, Polyhydroxyalkylmethacrylate und Polymaleinsäurehydroxyalkylester und Copolymere mit unsubstituierten oder substituierten Olefinen als Comonomeren; Polyacrylamide und Polymethacrylamide und Copolymere mit unsubstituierten oder substituierten Olefinen als Comonomeren; Polyaminoalkylacrylsäureester, methacrylsäurester und maleinsäureester und Copolymere mit unsubstituierten oder substituierten Olefinen als Comonomeren; Polyhydroxyalkyl- oder Polyaminoalkylvinylalkohol und Copolymere mit unsubstituierten oder substituierten Olefinen als Comonomeren; hydroxylierte Polybutadiene aus Butadien, Isopren oder Chloropren und Copolymere mit unsubstituierten oder substituierten Olefinen als Comonomeren; Hydroxy- oder Aminopolystyrol, Chlormethypolystyrol, und Polystyrolsulfonsäure und Copolymere mit unsubstituierten oder substituierten Olefinen als Comonomeren; Polyglycidylether und hydroxyalkylierte oder aminoatkylierte Polyglycidylether; und Polyester, Polyamide und Polyurethane mit hydroxylgruppenhaltigen Monomeren. Weiter geeignete Polymere sind Polyvinylpyridin, Polyvinylimidazol und Polyvinylpyrrolidon und und Copolymere mit unsubstituierten oder substituierten Olefinen als Comonomeren.

Bevorzugt sind Polymerisate auf der Basis funktionell substituierter ethylenisch ungesättigter Monomerer.

In einer bevorzugten Ausführungsform enthalten die erfindungsgemässen Polymerisate 100 bis 0,1 Mol-% gleiche oder verschiedene Strukturelemente der Formel VII, 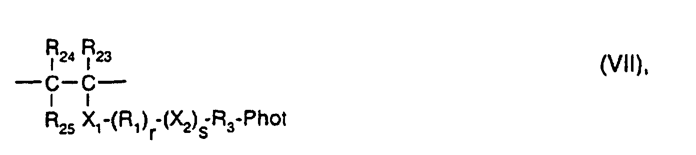 und 0 bis 99,9 Mol-% gleiche oder verschiedenen Strukturelemente der Formel VIII, 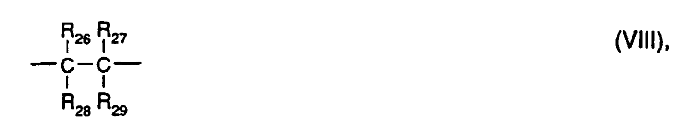 worin
X₁ und X₂ unabhängig voneinander eine direkte Bindung, oder X₂ und X₁ zusammen mit der funktionellen Gruppe unabhängig voneinander -O-, -S-, -NR₂-, -C(O)-O-, -O-C(O)-, -O-C(O)-O-, --SO₂-O-, -O-SO₂-, -O-SO₂-O-, -NR₂-C(O)-, -C(O)-NR₂-, -NR₂-C(O)-O-, O-C(O)-NR₂-, -NR₂-C(O)-NR₂-, -NR₂-SO₂-, -SO₂-NR₂-, -NR₂-SO₂-O-, O-SO₂-NR₂- oder -NR₂-SO₂-NR₂- bedeuten,
R₁ eine bivalente Brückengruppe darstellt,
Phot für einen monovalenten Rest eines Photoinitiators steht,
R₂ für H, C₁-C₁₂-Alkyl, C₅- oder C₆-Cycloalkyl, C₅- oder C₆-Cycloalkylmethyl oder -ethyl, Phenyl, Benzyl oder 1-Phenyleth-2-yl steht,
R₃ eine direkte Bindung, C₁-C₁₈-Alkylen, C₅- oder C₆-Cycloalkylen, C₆-C₁₀-Arylen oder C₇-C₁₂-Aralkylen bedeutet,
r die Zahlen 0 oder 1 und s die Zahlen 0 oder 1 bedeuten, und s für 0 steht, wenn r 0 darstellt,
R₂₃ und R₂₄ unabhängig voneinander H, C₁-C₆-Alkyl, C₆-C₁₀-Aryl oder C₇-C₁₂-Aralkyl bedeuten.
R₂₅ H oder die Gruppe -C(O)O-R₃₀ bedeutet,
R₂₆ H, C₁-C₆-Alkyl, C₆-C₁₀-Aryl oder C₇-C₁₂-Aralkyl bedeutet,
R₂₇ H, F, Cl, CN, C₁-C₆-Alkyl oder C₆-C₁₀-Aryl darstellt,
R₂₈ H, C₁-C₆-Alkyl oder -C(O)O-R₂₉ bedeutet,
R₂₉ für H, C₁-C₆-Alkyl, C₆-C₁₀-Aryl, C₇-C₁₂-Aralkyl, Imidazolyl, Pyrrolidonyl, F, Cl, CN oder die Gruppe X₁-(R₁)ᵣ-(X₂)ₛ-H steht, und
R₃₀ H, K, Na, C₁-C₁₈-Alkyl, C₁-C₁₈-Hydroxyalkyl, Cyclohexyl, Cyclopentyl, Cyclohexylmethyl, Phenyl, C₁-C₄-Alkylphenyl, Benzyl oder C₁-C₄-Alkylphenylbenzyl darstellt.

Für X₁, X₂, R₁, R₂, R₃, r, s und Phot gelten unabhängig die zuvor angegebenen Ausführungsformen und Bevorzugungen.

R₂₃ und R₂₄ bedeuten als Alkyl bevorzugt C₁-C₄-Alkyl, zum Beispiel Methyl, Ethyl, n- oder i-Propyl und n-, i- oder t-Butyl, als Aryl bevorzugt Naphthyl oder Phenyl und als Aralkyl bevorzugt Benzyl. Besonders bevorzugt steht stehen R₂₃ für H und R₂₄ für H oder Methyl.

R₂₅ bedeutet bevorzugt H, -C(O)OH oder -C(O)O-C₁C₄-Alkyl.

R₂₆ bedeutet als Alkyl bevorzugt C₁-C₄-Alkyl, zum Beispiel Methyl, Ethyl, n- oder i-Propyl und n-, i- oder t-Butyl, als Aryl bevorzugt Naphthyl oder Phenyl und als Aralkyl bevorzugt Benzyl. Besonders bevorzugt steht R₂₆ für H.

R₂₇ stellt als Alkyl bevorzugt C₁-C₄-Alkyl, zum Beispiel Beispiel Methyl, Ethyl, n- oder i-Propyl und n-, i- oder t-Butyl, und als Aryl bevorzugt Phenyl und Naphthyl dar. Besonders bevorzugt ist R₂₇ H, Cl, CN, Phenyl oder C₁-C₄-Alkyl.

R₂₈ bedeutet als Alkyl bevorzugt C₁-C₄-Alkyl, zum Beispiel Beispiel Methyl, Ethyl, n- oder i-Propyl und n-, i- oder t-Butyl. In der Gruppe -C(O)O-R₃₀ bedeutet R₃₀ bevorzugt H oder C₁-C₁₂-Alkyl, bevorzugter C₁-C₆-Alkyl, wie zum Beispiel Methyl, Ethyl, Propyl, Butyl, Pentyl, Hexyl, Heptyl, Octyl, Nonyl, Decyl, Undecyl, Dodecyl, Tetradecyl Hexadecyl und Octadecyl. Besonders bevorzugt bedeutet R₂₈ H, -C(O)OH oder -C(O)-O-C₁-C₄-Alkyl.

R₂₉ stellt als Alkyl bevorzugt C₁-C₄-Alkyl, zum Beispiel Beispiel Methyl, Ethyl, n- oder i-Propyl und n-, i- oder t-Butyl, als Aryl bevorzugt Phenyl und Naphthyl und als Aralkyl bevorzugt Benzyl dar. R₂₉ steht bevorzugt für H. C₁-C₄-Alkyl, Phenyl, Pyrrolidonyl, F, Cl, CN oder die Gruppe X₁-(R₁)ᵣ-(X₂)ₛ-H.

R₂₉ kann zum Beispiel H, K, Na, C₁-C₆-Alkyl, C₁-C₆-Hydroxyalkyl, Cyclohexyl, Cyclopentyl, Cyclohexylmethyl, Phenyl, Methylphenyl, Benzyl oder Methylphenylbenzyl darstellen.

Die Strukturelemente der Formel VII können in einer Menge von 0,1 bis 100 Mol-%, bevorzugt 0,5 bis 90 Mol-%, bevorzugter 0,5 bis 80 Mol-%, noch bevorzugter 1 bis 80 Mol-%, besonders bevorzugt 1 bis 60 Mol-%, insbesondere bevorzugt 1 bis 50 Mol-%, und ganz besonders bevorzugt 1 bis 30 Mol-% enthalten sein.

Die Strukturelemente der Formel VIII können in einer Menge von 99,9 bis 0 Mol-%, bevorzugt 99,5 bis 0 Mol-%, bevorzugter 99,5 bis 20 Mol-%, noch bevorzugter 99 bis 20 Mol-%, besonders bevorzugt 99 bis 40 Mol-%, insbesondere bevorzugt 99 bis 50 Mol-%, und ganz besonders bevorzugt 99 bis 30 Mol-% enthalten sein.

Photoinitiatoren können zur Erhöhung der Empfindlichkeit zusammen mit Sensibilisatoren oder Coinitiatoren verwendet werden. In einer bevorzugten Ausführungsform der Erfindung sind die Sensibilisatoren und Coinitiatoren über funktionelle Gruppen kovalent an das Polymer gebunden. Bekannte Sensibilisatoren und Coinitiatoren sind zum Beispiel Xanthone, Anthrachinone, Naphthacenchinone, Thioxanthone, Ethanolamine, Aminobenzoesäuren und Michler's Keton. Solche funktionalisierte Sensibilisatoren und Coinitiatoren sind in grosser Zahl bekannt und werden daher hier nicht näher ausgeführt. Für die Immobilisierung kommen die zuvor beschriebenen Brückengruppen und funktionelle Gruppen in Frage. Bevorzugt sind im erfindungsgemässen Polymer 0,1 bis 100 Mol-%, bevorzugt 0,5 bis 90 Mol-%, bevorzugter 0,5 bis 80 Mol-%, noch bevorzugter 1 bis 80 Mol-%, besonders bevorzugt 1 bis 60 Mol-%, insbesondere bevorzugt 1 bis 50 Mol-%, und ganz besonders bevorzugt 1 bis 30 Mol-% der Strukturelemente der Formel VIII durch Strukturelemente der Formel IX ersetzt, 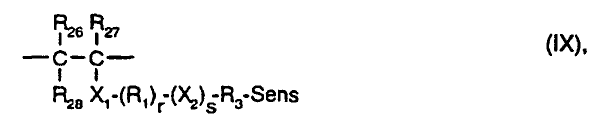 worin R₁, R₃, R₂₆, R₂₇, R₂₈, X₁, X₂, r und s unabhängig die vorangehenden Bedeutungen haben, einschliesslich der bevorzugten Ausgestaltungen, und Sens für den monovalenten Rest eines Coinitiators oder Sensibilisators steht.

Die Angaben in Mol-% ergänzen sich stets zu 100 %.

In einer bevorzugten Ausführungsform sind an das Polymer zusätzlich radikalisch oder kationisch photopolymerisierbare organische Verbindungen kovalent gebunden, die vorzugsweise den in der polymerisierbaren Zusammensetzung verwendeten Art an organischen polymerisierbaren Verbindungen entsprechen. In radikalisch polymerisierbaren ethylenisch ungesättigten System verwendet man demnach vorteilhaft ethylenisch ungesättigte Verbindungen mit funktionellen Gruppen, und in kationisch polymerisierbaren Systemen wie zum Beispiel Di- oder Polyepoxiden zweckmässig Di- oder Polyepoxide mit funktionellen Gruppen.

Bevorzugt werden Strukturelemente ethylenisch ungesätigter organischer Verbindungen mit kovalent gebundenen Olefingruppen, die in grosser Zahl bekannt sind. Die an das Polymer kovalent gebundenen Reste ethylenisch ungesätigter organischer Verbindungen können zum Beispiel Strukturelementen der Formel X entsprechen, 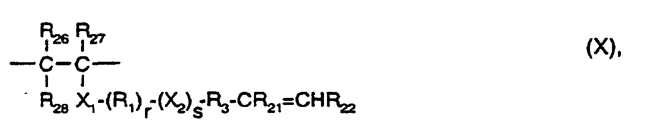 worin
X₁ und X₂ unabhängig voneinander eine direkte Bindung, oder X₂ und X₁ zusammen mit der funktionellen Gruppe unabhängig voneinander -O-, -S-, -NR₂-, -C(O)-O-, -O-C(O)-, -O-C(O)-O-, --SO₂-O-, -O-SO₂-, -O-SO₂-O-, -NR₂-C(O)-, -C(O)-NR₂-, -NR₂-C(O)-O-, O-C(O)-NR₂-, -NR₂-C(O)-NR₂-, -NR₂-SO₂-, -SO₂-NR₂-, -NR₂-SO₂-O-, O-SO₂-NR₂- oder -NR₂-SO₂-NR₂- bedeuten,
R₁ eine bivalente Brückengruppe darstellt,
R₂ H, C₁-C₁₂-Alkyl, C₅- oder C₆-Cyctoalkyl, C₅- oder C₆-Cycloalkylmethyl oder -ethyl, Phenyl, Benzyl oder 1-Phenyleth-2-yl steht,
R₃ eine direkte Bindung, C₁-C₁₈-Alkylen, C₅- oder C₆-Cycloalkylen, C₆-C₁₀-Arylen oder C₇-C₁₂-Aralkylen bedeutet,
r die Zahlen 0 oder 1 und s die Zahlen 0 oder 1 bedeuten, und s für 0 steht, wenn r 0 darstellt;
R₂₁ H oder C₁-C₄-Alkyl, besonders Methyl bedeutet;
R₂₂ H, C₁-C₁₂-Alkyl, Phenyl oder Benzyl darstellt; und
R₂₆, R₂₇ und R₂₈ die für Formel VIII angegebenen Bedeutungen haben.

Für X₁, X₂, R₁, R₂ und R₃ gelten die bei Formel I dargestellten Bevorzugungen. R₂₁ ist bevorzugt H oder Methyl, und R₂₂ ist bevorzugt H.

Die Strukturelemente der Formel X können 0,1 bis 99,9999 Mol-%, bevorzugt 0,5 bis 90 Mol-%, bevorzugter 0,5 bis 80 Mol-%, noch bevorzugter 1 bis 80 Mol-%, besonders bevorzugt 1 bis 60 Mol-%, insbesondere bevorzugt 1 bis 50 Mol-%, und ganz besonders bevorzugt 1 bis 30 Mol-% der Strukturelemente der Formel VIII ersetzen.

Die erfindungsgemässen Polymer können ferner mit wenigstens difunktionellen Monomeren vernetzt sein, zum Beispiel 0,01 bis 30 Mol-%, bevorzugt 0,1 bis 15 Mol-% solcher Monomerer, bezogen auf das Polymer. Je nach Art des Polymers können hierzu wenigstens trifunktionelle Carbonsäure, Isocyanate, Alkohole, Amine oder Epoxide verwendet werden, beziehungsweise für Polymerisate wenigstens zwei ethylenisch ungesättigte Gruppen enthaltende organische Verbindungen. Diese Vernetzungsmittel sind in grosser Zahl bekannt. Bei den ethylenisch ungesättigten Vernetzungsmitteln kann es sich zum Beispiel um Divinylbenzol, Bis-dimethylmaleinimid-alkylene (zum Beispiel Bis-(dimethylmaleinimidyl)-methylen oder -ethylen), Acrylsäure- oder Methacrylsäureester oder -amide von Polyolen, bevorzugt Diolen bis Tetrolen, beziehungsweise Polyaminen, bevorzugt Diaminen bis Tetraminen. Bevorzugt sind aliphatische, cycloaliphatische und cycloaliphatisch-aliphatische Diole und Diamine mit besonders bevorzugt 2 bis 12, insbesondere bevorzugt 2 bis 8 C-Atomen. Einige Beispiele für diese Diole sind Alkylendiole wie Ethylenglykol, 1,2- oder 1,3-Propandiol, 1,2-, 1,3- und 1,4-Butandiol, Pentandiol, Hexandiol, Octandiol, Decandiol, Dodecandiol, Cyclohexandiol, Di(hydroxymethyl)-cyclohexan, Polyoxaalkylenglykole von bevorzugt C₂-C₆-Alkylendiolen mit bevorzugt 2 bis 100 Alkylendioleinheiten, besonders bevorzugt 2 bis 50 Alkylendioleinheiten, und gabz besonders bevorzugt 2 bis 20 Alkylendioleinheiten, wie zum BeispielPolyethylenglykole, Polypropylenglykole, Polybutylenglykole und Polyethylen/Polypropylenglykole, ferner 1,1,1-Trihydroxymethylethan oder -propan, Pentaerythrit und Dipentaerythrit. Einige Beispiele für Polyamine sind Ethylendiamin, 1,3- und 1,3-Propandiamin, 1,2-, 1,3- und 1,4-Butandiamin, 1,6-Hexandiamin, Diethylentriamin, Triethylentetramin, Cyclohexandiamin, Aminomethylcyclohexanamin, Isophorondiamin und Di(aminomethyl)cyclohexan.

Die Gruppe -X₁-(R₁)ᵣ-(X₂)ₛ-R₃- steht in den Strukturelementen der Formel XI bevorzugt für -C(O)-O-, -C(O)-O-C₁-C₆-Alkylen-O-, -C(O)-O-(C₂-C₆-Alkylen-O)ᵤ- mit u gleich einer Zahl von 2 bis 10, -C(O)-O-(C₂-C₆-Alkylen-O)ᵤ-C₁-C₆-Alkylen- mit u gleich einer Zahl von 2 bis 10, und -C(O)-O-C₁-C₆-Alkylen-S-.

Der Rest "Phot" kann zum Beispiel Reste der Formeln 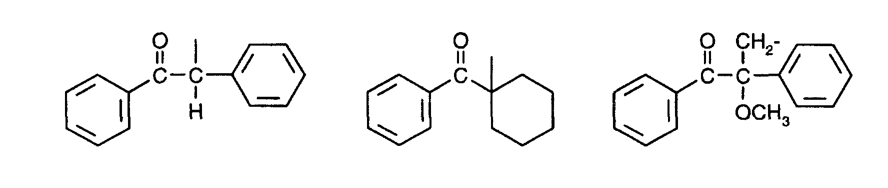 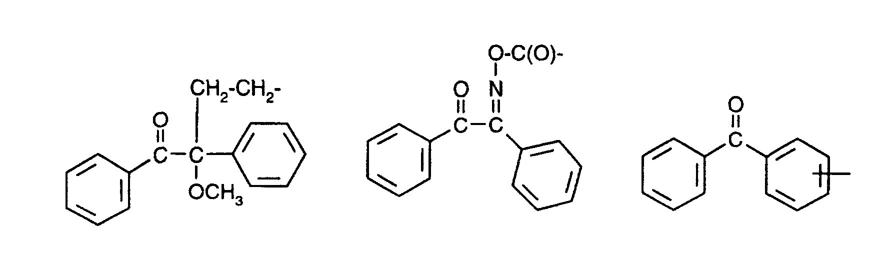 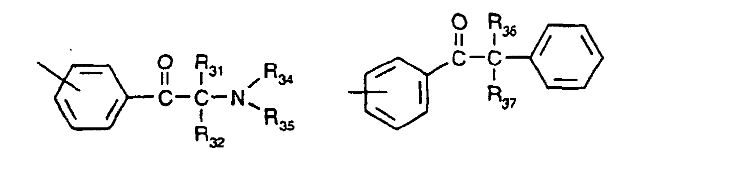 darstellen, worin
R₃₁ und R₃₂ unabhängig voneinander C₁-C₆-Alkyl, C₃-C₆-Alkenyl, C₅- oder C₆-Cycloalkyl, C₇-C₁₂-Aralkyl und besonders Allyl, Benzyl oder R₃₁ und R₃₂ zusammen Tetra- oder Pentamethylen bedeuten, R₃₄ und R₃₅ unabhängig voneinander C₁-C₁₂- und bevorzugt C₁-C₆-Alkyl, C₅- oder C₆-Cycloalkyl, C₇-C₁₂-Aralkyl und bevorzugt Benzyl oder 1-Phenyleth-2-yl sind, oder R₃₄ und R₃₅ zusammen Tetramethylen, Pentamethylen, -CH₂CH₂-O-CH₂CH₂- oder -CH₂CH₂-N(C₁-C₄-Alkyl)-CH₂CH₂ darstellen, und R₃₆ und R₃₇, unabhängig voneinander C₁-C₆-Alkoxy, C₅- oder C₆-Cycloalkoxy, Phenyloxy oder Phenyl-C₁-C₄-alkoxy bedeuten, oder R₃₆ und R₃₇ zusammen für C₂-C₄-Alkylendioxyl oder C₂-C₄-Alkenylendioxyl stehen.

Die bevorzugten Polymerisate können neben den Strukturelementen der Formel XI auch gleiche oder verschiedene Strukturelemente der Formel XII enthalten, 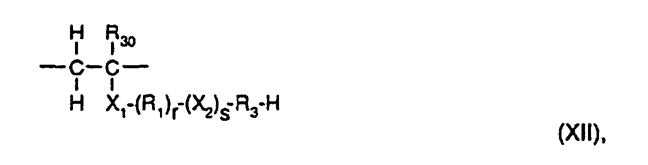 worin R₃₀, X₁, X₂, R₁, R₃, r und s die vorher angegebenenen Bedeutungen haben. Diese Strukturelemente sind besonders dann vorhanden, wenn die die Gruppe "Phot" durch Umsetzung eines Polymers mit funktionellen Gruppen und einem Photoinitiator mit funktionellen Gruppen hergestellt wird.

Die bevorzugten Polymerisate können neben den Strukturelementen der Formel XI auch gleiche oder verschiedene Strukturelemente der Formel XIII enthalten, 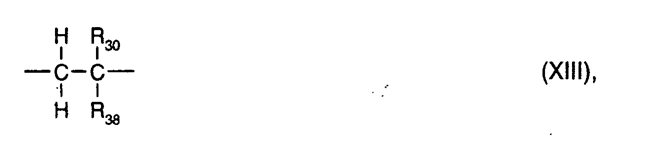 R₃₀ H oder Methyl darstellt, und
R₃₈ H, C₁-C₄-Alkyl, C₁-C₄-Alkoxy, -CN, Cl, Phenyl, Pyrrolidonyl, Pyridinyl, Imidazolyl, -C(O)OR₃₉ oder -C(O)-NR₄₀R₄₁ darstellen,
R₃₉ H oder C₁-C₁₈- und bevorzugt C₁-C₁₂-Alkyl bedeutet, und
R₄₀ und R₄₁ unabhängig voneinander H oder C₁-C₁₂- und bevorzugt C₁-C₆-Alkyl darstellen.

In einer weiteren bevorzugten Ausführungsform enthalten die erfindungsgemässen Polymerisate mit Strukturelementen der Formel XI und gegebenenfalls der Formeln XII, XIII, XIV und XV gleiche oder verschiedene Strukturelemente, die ionogene Gruppen wie zum Beispiel -C(O)O⁻ oder -SO₃⁻ oder Ammoniumgruppen in Seitenketten gebunden enthalten, oder die wenigstens zwei ionenbildende Strukturelemente, zum Beispiel Strukturelemente mit Amingruppen und Strukturelemente mit -C(O)O⁻ oder -SO₃⁻ in Seitenketten gebunden enthalten. Bei diesen Polymeren handelt es sich bevorzugt um Emulsionspolymerisate beziehungsweise eine Latex.

In einer besonders bevorzugten Ausführungsform handelt es sich bei den Polymerisaten mit den Strukturelementen der Formel XI und gegebenenfalls Strukturelementen der Formeln XII, XIII, XIV und/oder XV um solche, die zusätzlich gleiche oder verschiedene ionogene Strukturelemente der Formeln XVI enthalten, 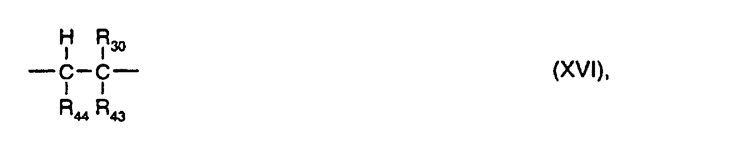 worin
R₃₀ für H oder Methyl steht, und
R₄₄ H bedeutet und R₄₃-C(O)OR₄₅, -SO₃R₄₅, -C₆H₄-COOR₄₅, -C₆H₄-SO₃R₄₅, -C₆H₄-R₄₆ oder -C(O)-X₄-C₂-C₆-Alkylen-R₄₇ darstellt,
R₄₃ und R₄₄ unabhängig voneinander -C(O)OR₄₅ oder -C(O)-X₄-C₂-C₆-Alkylen-R₄₇ darstellen,
R₄₅ ein Alkalimetall, bevorzugt Li, Na oder K, bedeutet,
R₄₆ eine Ammoniumgruppe oder eine Ammoniummethylgruppe darstellt, und
R₄₇ eine Ammoniumgruppe bedeutet.

Die Ammoniumgruppen oder das Ammonium in der Ammoniummethylgruppe können sich von primären, sekundären oder tertiären Amingruppen ableiten; bevorzugt handelt es um quaternäre Ammoniumgruppen. Die Ammoniumgruppen oder das Ammonium in der Ammoniummethylgruppe können zum Beispiel der Formel XVII entsprechen,

-⁺NR₄₈R₄₉R₅₀ (XVII),

worin R₄₈, R₄₉ und R₅₀ unabhängig voneinander H, unsubstituertes oder mit oder mit -O(O)C C R₃₀=CH₂ substituiertes C₁-C₁₈-, bevorzugt C₁-C₁₂- und bevorzugter C₁-C₆-Alkyl, C₅- oder C₆-Cycloalkyl, Phenyl, Benzyl, 1-Phenyl-eth-2-yl, darstellen, oder
R₄₈ und R₄₉ zusammen Tetramethylen, Pentamethylen oder -CH₂CH₂-O-CH₂CH₂- bedeuten und R₅₀ die zuvor angegebene Bedeutung hat.

Als Gegenionen eignen sich die Anionen anorganischer oder organischer Säuren, wie zum Beispiel Carbonsäuren, Sulfonsäuren und Halogenwasserstoffsäuren. Bevorzugt sind Chlorid und Bromid. Mit der Quaternisierung können gleichzeitig weitere ethylenisch ungesättigte Gruppen kovalent gebunden werden. Bevorzugt sind quaternäre Ammoniumgruppen.

Die erfindungsgemässen Polymerisate mit den Strukturelementen der Formel XI und gegebenenfalls Strukturelementen der Formeln XII, XIII, XIV, und/oder XV können zusätzlich Strukturelemente mit sauren Gruppen wie zum Beispiel -C(O)OH oder -SO₃H, und zusätzlich Strukturelemente mit basischen Gruppen, wie zum Beispiel primären, sekundären oder tertiären Amingruppen enthalten, besonders wenn es sich um Emulsionspolymerisate handelt

In einer anderen besonders bevorzugten Ausführungsform handelt es sich bei den Polymerisaten mit den Strukturelementen der Formel XI und gegebenenfalls Strukturelementen der Formeln XII, XIII, XIV, und/oder XV um solche, die zusätzlich gleiche oder verschiedene Strukturelemente der Formeln XVIII und XIX enthalten, 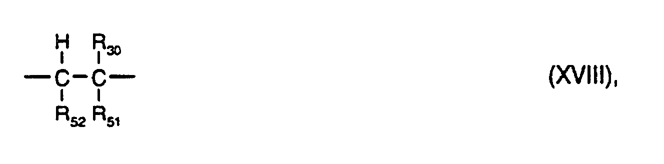 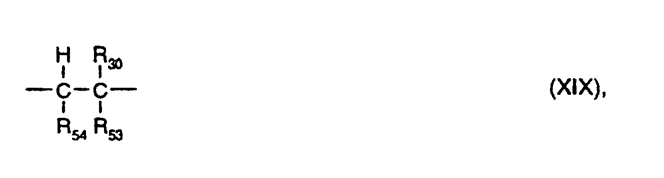 worin
R₃₀ für H oder Methyl steht,
R₅₂ H bedeutet und R₅₁ -C(O)OH, -SO₃H, -C₆H₄-COOH, -C₆H₄-SO₃H darstellt,
R₅₁ und R₅₂-C(O)OH darstellen,
R₅₄ H und R₅₃ Pyridinyl, Imidazolyl, Pyrrolidonyl, -C₆H₄-R₅₅ oder -C(O)-X₄-C₂-C₆-Alkylen-R₅₆ darstellt,
X₄ für -O-, -NH- oder -N(C₁-C₄-Alkyl) steht,
R₅₃ und R₅₄ unabhängig voneinander -C(O)-X₄-C₂-C₆-Alkylen-R₅₆ darstellen,
R₅₅ eine Amingruppe oder eine Aminomethylgruppe darstellt, und
R₅₆ eine Amingruppe bedeutet.

Die Amingruppe und die Amingruppe in der Aminomethylgruppe entspricht bevorzugt der Formel XX,

-NR₄₈R₄₉ (XX),

worin
R₄₈ und R₄₉ unabhängig voneinander H, unsubstituertes oder mit oder mit
-O(O)C C R₃₀=CH₂ substituiertes C₁-C₁₈-, bevorzugt C₁-C₁₂- und bevorzugter C₁-C₆-Alkyl, C₅- oder C₆-Cycloalkyl, Phenyl, Benzyl, 1-Phenyl-eth-2-yl, darstellen, oder
R₄₈ und R₄₉ zusammen Tetramethylen, Pentamethylen oder -CH₂CH₂-O-CH₂CH₂- bedeuten.

Bevorzugt sind sekundäre Amingruppen, besonders Di(C₁-C₄-Alkylamino), wie zum Beispiel Dimethylamino, Diethylamino, Di-n-Propylamino und Di-n-Butylamino.

Eine bevorzugte Untergruppe an Polymerisaten, die neben den Strukturelementen der Formel XI und gegebenenfalls Strukturelementen der Formeln XII, XIII, XIV und/oder XV enthalten sein können, sind solche, die nachträglich zu quaternären Ammoniumgruppen modifiziert werden können. Solche Gruppen sind zum Beispiel Amingruppen oder Halogenalkylgruppen, die entweder mit üblichen Alkylierungsmitteln beziehungsweise mit sekundären Aminen umgesetzt werden können, wobei diese Umsetzung in Lösung homogen oder nachträglich zur Modifizierung von Oberflächen der Mikropartikel heterogen geführt werden kann Diese Strukturelemente entsprechen bevorzugt der Formel XXI, 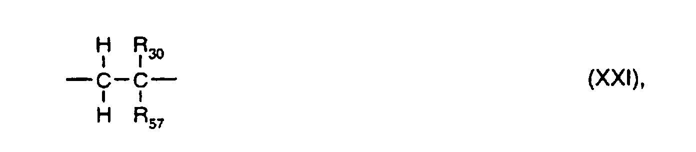 worin
X₄ für -O-, -NH- oder -N(C₁-C₄-Alkyl)- steht,
R₃₀ für H oder Methyl steht, und
R₅₇ -C₆H₄-CH₂Cl, -C₆H₄-CH₂Br, -C₆H₄-CH₂CH₂Cl, -C₆H₄-CH₂CH₂Br, -C(O)-X₄-C₂-C₆-AlkylenCl, -C(O)-X₄-C₂-C₆-Alkylen-Br, Pyridinyl, Imidazolyl, Pyrrolidonyl, -C₆H₄-R₅₅ oder -C(O)-X₄-C₂-C₆-Alkylen-R₅₆ bedeutet,
R₅₅ eine Amingruppe oder eine Aminomethylgruppe darstellt, und
R₅₆ eine Amingruppe bedeutet.

Für X₄ R₅₅ und R₅₆ gelten die zuvor beschriebenen Bevorzugungen und Ausführungsformen.

Das erfindungsgemässe Polymer mit den Strukturelementen der Formel XI kann neben den zusätzlich möglichen Strukturelementen auch Strukturelemente mit kovalent gebundenen Sensibilisatoren oder Coinitiatoren enthalten, wie sie zuvor beschrieben worden sind. Bevorzugt sind Strukturelemente der Formel XXII, 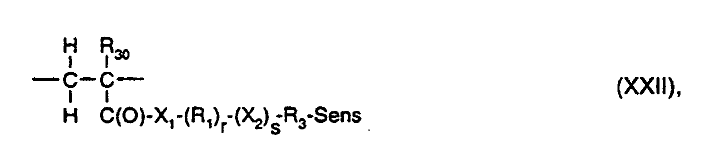 worin
R₃₀ für H oder Methyl steht,
R₁, R₃, X₁, X₂, r und s die zuvor angegebenen Bedeutungen haben, einschliesslich der Ausführungsformen und Bevorzugungen, und
Sens einen Rest der Formel XXIII darstellt, 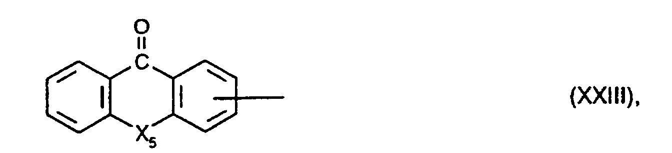 worin
X₅ für -O- und bevorzugt für -S- steht.

Einige Beispiele für polymerisierbare Reste, von denen sich der Rest der Formel XXII ableitet, sind 1-, 2- oder 3-Carboxylthioxanthon oder-xanthon, Thioxanthon-2-ethylacrylat, Thioxanthon-2-methacrylat, Thioxanthon-2-(oxaethyl)acrylat oder- methycrylat, Thioxanthon-2-(thioethyl)acrylat oder- methycrylat, Thioxanthon-2-acrylamid oder 2-methacrylamid.

Die Polymere mit den Strukturelementen der Formel X enthalten diese Strukturelemente bevorzugt in einer Menge von 1 bis 30, bevorzugt 2 bis 15 Gew.-%, bezogen auf das Polymer. Die Strukturelemente der Formel XII können in einer Menge von 99 bis 0, bevorzugt 98 bis 0 Gew.-% enthalten sein. Die Strukturelemente der Formel XIII können in einer Menge von 99 bis 0, bevorzugt 98 bis 0 Gew.-% enthalten sein. Die Strukturelemente der Formeln XIV und XV können in einer Menge von 0,1 bis 30, bevorzugt 1 bis 15 Gew.-% enthalten sein. Die Strukturelemente der Formel XVI können in einer Menge von 99 bis 0, bevorzugt 98 bis 10 Gew.-% enthalten sein. Die Strukturelemente der Formel XVIII und XIX können in einer Menge von 99 bis 0, bevorzugt 98 bis 10 Gew.-% enthalten sein. Die Strukturelemente der Formel XXI können in einer Menge von 99 bis 0, bevorzugt 98 bis 10 Gew.-% enthalten sein. Die Strukturelemente der Formel XXII können in einer Menge von 99 bis 0, bevorzugt 98 bis 10 Gew.-% enthalten sein. Die Gewichtsprozente addieren sich zu 100 Gew.-%.

Bei den erfindungsgemässen Polymeren mit Strukturelementen der Formeln VII oder XI handelt es sich bevorzugt um Emulsionspolymerisate.

Die Herstellung der erfindungsgemäss zu verwendenden Polymere kann nach den in der Polymerchemie bekannten Verfahren erfolgen. Die Monomeren sind bekannt oder können nach bekannten Verfahren hergestellt werden. Bekannte Polymerisationsverfahren sind Lösungspolymerisation, Massepolymerisation, Emulsionspolymerisation und Grenzflächenpolymerisation. Vorteilhaft wird das Verfahren der Emulsionspolymerisation bei hohen Rührgeschwindigkeiten angewendet, da man die erfindungsgemässen Mikropartikel so direkt herstellen kann, und nachträgliche Behandlungen wie zum Beispiel ein Mahlen vermeiden kann. Auch das Mahlen von Polymeren ist allgemein bekannt. Geeignet sind zum Beispiel Kugelmühlen. Zur Schonung der Polymeren kann das Mahlen unter Kühlen vorgenommen werden. Die Herstellung der erfindungsgemässen Mikropartikel kann auch, wie zuvor für die Modifizierung von Oberflächen in einer heterogenen Reaktion, durch die Umsetzung von natürlichen oder synthetischen Polymeren mit funktionellen Gruppen und funktionalisierten Photoinitiatoren und gegebenenfalls weiteren funktionalisierten Verbindungen wie Cokatalysatoren, Sensibilisatoren oder polymerisierbaren Verbindungen, in Lösung erfolgen. Mikropartikel können dann durch Fällung aus den Lösungen oder Vermahlen der isolierten modifizierten Polymere erhalten werden. Bei dieser Herstellung können ebenfalls die bekannten Methoden zur Einführung von Spacern angewendet werden. Insbesondere ist es auch möglich, Polymere mit den Strukturelementen der Formel VII und weiteren Strukturelementen mit funktionellen Gruppen nachträglich an der Oberfläche zu modifizieren und polymerisierbare Gruppen und/oder Sensibilisatoren beziehungsweise Coinitiatoren nur an der Oberfläche der Mikropartikel kovalent zu binden.

Die erfindungsgemässen Mikropartikel sind hervorragende Photoinitiatoren für die durch aktinische Strahlung induzierte radikalische oder kationische Polymerisation von Monomeren. Sie weisen eine erhöhte Empfindlichkeit auf, die Polymerisationszeit ist kürzer und sie bilden während der Polymerisationszeit stabile Dispersionen. Die physikalischen und mechanischen Eigenschaften sind gegenüber mit klassischen und löslichen Photoinitiatoren hergestellten Polymeren verbessert. Die Mikropartikel sind lagerstabil, wobei eine Lagerung unter Lichtausschluss empfehlenswert sein kann. Es handelt sich um rieselfähige Pulver oder Latices. Sie können leicht formuliert werden, wobei auch formulierte Systeme unter Lichtausschluss eine hohe Lagerstabilität aufweisen. Latices können als solche verwendet werden, wenn man mit der Wahl von Lösungsmitteln oder Monomeren die Löslichkeit der Monomeren in der Latex abstimmt.

Ein weiterer Gegenstand der Erfindung ist eine photopolymerisierbare und/oder photovernetzbare Zusammensetzung, enthaltend (a) gleiche oder verschiedene nichtflüchtige radikalisch oder kationisch photopolymerisierbare oder photovernetzbare Monomere, und (b) einen heterogenen Photoinitiator in Form von Mikropartikeln, wie vorstehend beschrieben.

Die Menge des heterogenen Photoinitiators beträgt bevorzugt mindestens 0,001 Gew.-%, bevorzugter mindestens 0,01 Gew.-%, bezogen auf die Zusammensetzung. Die obere Grenze richtet sich nach der gewünschten Lichtempfindlichkeit oder der Erzielung zusätzlicher Effekte. Es können bis 20 Gew.-%, bevorzugt bis zu 15 Gew.%, noch bevorzugter bis zu 10 Gew.-%, besonders bevorzugt bis zu 5 Gew.-%, und insbesondere bis zu 3 Gew.-% enthalten sein, wenn im wesentlichen die Photoinitiatorwirkung genutzt werden soll. Der heterogene Photoinitiator kann aber gleichzeitig als Füllstoff verwendet werden, wobei je nach Trägermaterial die physikalischen und/oder mechanischen Eigenschaften der hergestellten Polymeren beeinflusst werden können. Bei hohen Zusatzmengen kann eine ausreichende Lichtempfindlichkeit durch die Anpassung der Brechungsindice erfolgen, so dass transluszente oder transparente polymerisierbare Zusammensetzungen vorliegen. Es können für diesen Zweck bis zu 90 Gew.-%, bevorzugt 10 bis 80 Gew.-% und besonders bevorzugt 10 bis 60 Gew.-% in der Zusammensetzung enthalten sein.

Für den heterogenen Photoinitiator in der Zusammensetzung gelten ebenfalls die zuvor beschriebenen Ausführungsformen und bevorzugten Ausgestaltungen.

Photopolymerisierbare und photovernetzbare Monomere sind in grosser Vielzahl bekannt und zum Beispiel in Chemistry and Technology of UV & EB Formulations for Coatings, Inks and Paints, Vol. 2, Prepolymers and Reactive Diluents for UV and EB Curable Formulations, SDITA Technology, London 1991. Im Rahmen der Erfindung werden unter Monomeren auch Oligomere und Polymere, bevorzugt niedermolekulare Polymere mit Strukturelementen verstanden, die photopolymerisierbare Gruppen im Polymerrückgrat oder in Seitenketten kovalent oder ionogen gebunden enthalten. Solche Oligomeren und Polymeren sind ebenfalls in grosser Vieizahl bekannt geworden.

Unter den kationisch polymerisierbaren beziehungsweise versetzbaren Monomeren sind besonders Epoxidverbindungen mit mehr als einer Epoxidgruppe im Molekül zu nennen, die in grosser Vielzahl bekannt und in der Literatur beschrieben sind.

Unter den kationisch und radikalisch polymerisierbaren Monomeren sind besonders Monomere mit wenigstens einer ethylenisch ungesättigten Gruppe zu erwähnen, die dem Fachmann in grosser Zahl bekannt sind. Sie sind bevorzugt ausgewählt aus der Gruppe der substituierten Olefine, besonders den Acrylsäure- und Methacrylsäureestern und -amiden. Beispiele für Substituenten sind unsubstituiertes oder mit -OH, -CN Cl, F, C₁-C₁₂- und bevorzugt C₁-C₆-Alkoxy, -C(O)OH, -C(O)O-C₁-C₁₈-Alkyl, -C(O)O-C₁-C₁₈-Hydroxyalkyl, -C(O)OCyclohexyl, -C(O)OCH₂Cyclohexyl, -C(O)OPhenyl, -C(O)OBenzyl substituiertes C₁-C₁₈-, bevorzugt C₁-C₁₂-Alkyl; unsubstituiertes oder mit -OH, F, -Cl, C₁-C₁₂- und bevorzugt C₁-C₆-Alkoxy, C₁-C₁₂- und bevorzugt C₁-C₆-Hydroxyalkoxy, -C(O)OH, -C(O)O-C₁-C₁₈-Alkyl, -C(O)O-C₁-C₁₈-Hydroxyalkyl, -C(O)OCyclohexyl, -C(O)OCH₂Cyclohexyl, -C(O)OPhenyl, -C(O)OBenzyl substituiertes C₁-C₁₂-, bevorzugt C₁-C₆-Alkoxy; Cl, -CN, Pyrridinyl, Imidazolyl; unsubstituiertes oder mit C₁-C₄-Alkyl, C₁-C₄-Alkoxy, -OH, -CN, Halogen (wie zum Beispiel F, CI und Br), -C(O)OH, -C(O)-OC₁-C₁₈-Alkyl, -C(O)O-C₂-C₁₈-Hydroxyalkyl, -C(O)OCyclohexyl, -C(O)-OCH₂Cyclohexyl, -C(O)OPhenyl, -C(O)OBenzyl -SO₃H, -SO₃-C₁-C₁₈-Alkyl, Chlormethyl, Brommethyl, -NH₂, Primär- oder Sekundäramino mit 1 bis 20 C-Atomen, Primär- oder Sekundäraminomethyl mit 1 bis 20 C-Atomen substituiertes Phenyl; -C(O)OH, -C(O)-O-C₁-C₂₀-Alkyl oder -Hydroxyalkyl, -C(O)OCyclohexyl, -C(O)OCH₂Cyclohexyl, -C(O)OPhenyl, -C(O)OBenzyl -C(O)-O-(CₐH₂ₐO)-H mit a gleich einer Zahl von 2 bis 6, bevorzugt 2 bis 4, und b gleich einer Zahl von 2 bis 12, bevorzugt 2 bis 6; und -C(O)-NR₅₈R₅₉, worin R₅₈ und R₅₉ unabhängig voneinander H, C₁-C₁₂-, bevorzugt C₁-C₆-Alkyl, C₁-C₁₂-, bevorzugt C₂-C₆-Hydroxyalkyl, C₁-C₆-Alkyl-C(O)OH, C₁-C₆-Alkyl-C(O)O-C₁-C₁₂-Alkyl oder (CₐH₂ₐO)-H mit a gleich einer Zahl von 2 bis 6, bevorzugt 2 bis 4, und b gleich einer Zahl von 2 bis 12, bevorzugt 2 bis 6.

Zur Vernetzung können den monoethylenischen organischen Verbindungen mindestens diethylenisch ungesättigte organische Verbindungen zugegeben werden, zum Beispiel in Mengen von wenigstens 0,1 Gew.-%, bezogen auf die Monomeren. Solche Vemetzungsmittel sind zuvor erwähnt worden. Bevorzugt sind di- oder trifunktionelle ethylenisch ungesättigte Verbindungen. Es ist aber auch möglich, nur wenigstens diethylenisch ungesättigte Verbindungen als Monomere zu verwenden.

Häufig werden in der Technik mono- oder polyfunktionelle Acryl- oder Methacrylsäureester oder -amide verwendet, alleine oder in Abmischung von mindestens zwei solcher Ester oder Amide und /der in Abmischung mit wenigstens einem anderen ethylenisch mindestens einfach ungesättigten Monomeren. Die Ester oder Amide sind bekannt oder können nach analogen Verfahren hergestellt werden. Sie können der Formel XXIV entsprechen, 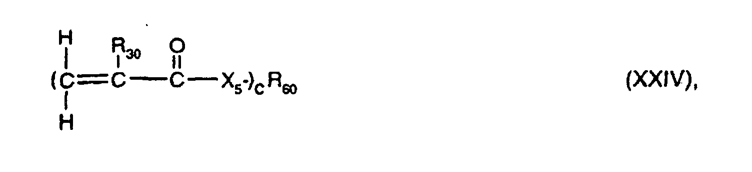 worin
R₃₀ H oder Methyl bedeutet,
c für eine Zahl von 1 bis 8 steht,
X die Gruppen -O-, -NH- oder -N(C₁-C₄-Alkyl)- darstellt, und
R₆₀ einen monovalenten bis octavalenten Kohlenwasserstoffrest mit 1 bis 50, bevorzugt 1 bis 30, und besonders bevorzugt 1 bis 20 C-Atomen bedeutet.

In Formel XXIV steht c bevorzugt eine Zahl von 1 bis 6, besonders bevorzugt 1 bis 4.

Der Kohlenwasserstoffrest kann ein oder mehrere gleiche oder verschiedene Gruppen ausgewählt aus Ether-, Thioether-, Amin-, Ester-, Carbonat-, Amid-, Harnstoff- und Urethangruppen enthalten, besonders, wenn mit Mitteln zur Kettenverlängerung Spacergruppen eingeführt werden. Der Kohlenwasserstoffrest kann ausgewählt sein aus gleichen oder verschiedenen Resten aus der Gruppe der aliphatischen, cycloaliphatischen, heterocycloaliphatischen cycloaliphatisch-aliphatischen, heterocycloaliphatisch-aliphatischen, aromatischen, heteroaromatischen, aromatisch-aliphatischen und heteroaromatisch-aliphatischen Reste.

Bevorzugt leitet sich R₆₀ von Alkoholen oder Aminen beziehungsweise Polyolen oder Polyaminen ab, wobei bei den Polyolen und Polyaminen freie OH- beziehungsweise Amingruppen vorhanden sein können. Die Monomeren der Formel XXIV sind vielfach bekannt oder können nach analogen Verfahren hergestellt werden.

Die erfindungsgemäße Zusammensetzung kann ein inertes Lösungsmittel enthalten. Inert bedeutet, dass sich die Wahl der Lösungsmittel nach der Reaktivität der in der Zusammensetzung enthaltenen Bestandteile richtet, und die Lösungsmittel so ausgewählt werden, dass keine unerwünschten Reaktionen eintreten können.

Geeignete inerte Lösungsmittel sind zum Beispiel protisch-polare und aprotische Lösungsmittel, die allein oder in Mischungen aus mindestens zwei Lösungsmitteln verwendet werden können. Beispiele sind: Wasser, Alkanole (Methanol, Ethanol, Propanol, Butanol, Ethylenglykolmonomethyl- oder -monoethylether, Ether (Dibutylether, Tetrahydrofuran, Dioxan, Ethylenglykolmonomethyl- oder -dimethylether, Ethylenglykolmonoethyl- oder -diethylether, Diethylenglykoldiethylether, Triethylenglykoldimethylether), halogenierte Kohlenwasserstoffe (Methylenchlorid, Chloroform, 1,2-Dichlorethan, 1,1,1-Trichlorethan, 1,1,2,2-Tetrachlorethan), Carbonsäureester und Lactone (Essigsäureethylester, Propionsäuremethylester, Benzoesäureethylester, 2-Methoxyethylacetat, γ-Butyrolacton, δ-Valerolacton, Pivalolacton), Carbonsäureamide und Lactame (N,N-Dimethylformamid, N,N-Diethyiformamid, N,N-Dimethylacetamid, Tetramethylhamstoff, Hexamethylphosphorsäuretriamid, γ-Butyrolactam, ε-Caprolactam, N-Methylpyrrolidon, N-Acetylpyrrolidon, N-Methylcaprolactam), Sulfoxide (Dimethylsulfoxid), Sulfone (Dimethylsulfon, Diethylsulfon, Trimethylensulfon, Tetramethylensulfon), tertiäre Amine (N-Methylpiperidin, N-Methylmorpholin), aliphatische und aromatische Kohlenwasserstoffe wie zum Beispiel Petrolether, Pentan, Hexan, Cyclohexan, Methylcyclohexan, Benzol oder substituierte Benzole (Chlorbenzol, o-Dichlorbenzol, 1,2,4-Trichlorbenzol, Nitrobenzol, Toluol, Xylol) und Nitrile (Acetonitril, Propionitril, Benzonitril, Phenylacetonitril).

Bevorzugte Lösungsmittel sind unter oekologischen Gesichtspunkten Wasser, Alkanole und Gemische aus Wasser und mit Wasser mischbaren Lösungsmitteln, unter Verwendung von in diesen Lösungsmitteln löslichen polymerisierbaren Monomeren.

Die erfindungsgemässen Zusammensetzungen sind lagerstabil unter Lichtausschluss, und unempfindlich gegen Luft und Feuchtigkeit, was eine Lagerhaltung sowie Reaktionsausführung ohne Schutzgas und sogar mit Wasser als Lösungsmittel ermöglicht. Die Zusammensetzung kann vor der photochemischen Polymerisation als gebrauchsfertige Formulierung gelagert werden, was für die grosstechnische Anwendung von Vorteil ist. Das Vermischen der Komponenten kann aber auch unmittelbar vor der Verarbeitung erfolgen.

Die erfindungsgemässe Zusammensetzung kann Formulierungshilfstoffe enthalten. Als solche sind die oben als Lösungsmittel angegebenen Verbindungen geeignet. Bekannte Hilfsstoffe sind Antioxidantien, Lichtschutzmittel, Weichmacher, Farbstoffe, Pigmente, Füllstoffe, Verstärkerfüllstoffe, Gleitmittel, Tenside und Entformungshilfsmittel.

Die Herstellung der erfindungsgemässen Zusammensetzung kann durch einfaches Vermischen der Komponenten erfolgen, wobei sich die ertindungsgemässen Photoinitiatoren besonders leicht einverleiben lassen, und Dispersionen mit einer gleichmässigen Verteilung der heterogenen Photoinitiatoren erhalten werden. Die Dispersionen sind im allgemeinen stabil, was im wesentlichen von der Viskosität der Zusammensetzung abhängt. Sofern sich die Mikropartikel absetzen oder konzentrieren, können sie durch erneutes Rühren in einfacher Weise wieder gleichmässig verteilt werden.

Aus der erfindungsgemässen Zusammensetzung können durch Einwirkung aktinischer Strahlung Formkörpern aller Art, Beschichtungen und Reliefabbildungen beziehungsweise Reliefstrukturen hergestellt werden. Die aktinische Strahlung kann von einer γ-Strahlung bis zum nahen IR-Bereich reichen. Die eingesetzte Strahlung richtet sich im wesentlichen nach der Absorption der verwendeten Photoinitiatoren. Bevorzugt wird Licht vom UV-Bereich bis in den sichtbaren Bereich verwendet. Geeignete Strahlungsquellen sind bekannt. Es kann sich zum Beispiel um Lampen oder Laser handeln. Bevorzugt werden UV-Lampen (Quecksilberdampflampen) oder UV-Laser verwendet. Die Bestrahlungsdauer ist von der Art der Lichtquelle abhängig; sie kann von Sekunden bis Minuten reichen.

Wenn die erfindungsgemässe Zusammensetzung zusätzlich Monomere enthält, die nach der Photoreaktion auch thermisch härtbar sind, kann sich eine thermische Härtung anschliessen. Ferner kann eine thermische Nachbehandlung nach der Photoreaktion vorteilhaft sein.

Das erfindungsgemässe Verfahren wird bevorzugt bei Raumtemperatur bis leicht erhöhter Temperatur durchgeführt. Eine Temperaturerhöhung dient der Erhöhung der Reaktionsgeschwindigkeit. Insbesondere wird das erfindungsgemäße Verfahren bei Temperaturen von Raumtemperatur bis +110° C durchgeführt.

Ein weiterer Gegenstand der Erfindung ist ein Verfahren zur Polymerisation oder Vernetzung einer photopolymerisierbaren und/oder photovernetzbaren Zusammensetzung, enthaltend (a) gleiche oder verschiedene nichtflüchtige radikalisch oder kationisch photopolymerisierbare oder photoversetzbare Monomere, und (b) einen Photoinitiator, das dadurch gekennzeichnet ist, dass der Photoinitiator als heterogener Photoinitiator in Form von Mikropartikeln vorliegt, der aus einem feinteiligen Trägermaterial besteht, an das gleiche oder verschiedene Photoinitiatoren, oder Photoinitiatoren und Sensibilisatoren oder Coinitiatoren kovalent gebunden sind.

Ein anderer Gegenstand der Erfindung sind die mit dem erfindungsgemässen Verfahren erhältlichen Polymeren aus gleichen oder verschiedenen nichtflüchtigen radikalisch oder kationisch photopolymerisierbaren oder photovernetzbare Monomeren, die dadurch gekennzeichnet sind, dass sie Mikropartikel enthalten, an die gleiche oder verschiedene Spaltprodukte von Photoinitiatoren, oder Photoinitiatoren und Sensibilisatoren oder Coinitiatoren kovalent gebunden sind.

Bei den Spaltprodukten handelt es sich um die durch aktinische Strahlung gebildeten Abbauprodukte des Photoinitiators. Die Anwesenheit von unverbrauchten kovalent gebundenen Photoinitiatoren hängt im wesentlichen von deren Konzentration in der polymerisierbaren Zusammensetzung ab.

Je nach verwendetem Monomer können die erfindungsgemässen Polymere sehr verschiedene Eigenschaften aufweisen. Einige zeichnen sich durch sehr hohe Sauerstoffpermeabilität, tiefe Dielektrizitätskonstanten, gute Wärmestabilität und geringe Wasserabsorption aus. Andere haben hervorragende optische Eigenschaften wie zum Beispiel hohe Transparenz und niedrige Brechungsindices, oder gute mechanische Eigenschaften. Ferner ist ein geringer Schrumpf und die ausgezeichnete Oberflächenglätte hervorzuheben. Daher können sie in sehr unterschiedlichen technischen Gebieten Verwendung finden.

Diese Polymeren eignen sich zur Herstellung von medizinischen Geräten, Implantaten oder Kontaktlinsen; zur Herstellung von elektronischen Bauteilen; als Bindemittel für Lacke; als photohärtbare Zusammensetzungen für den Modellbau oder als Klebstoffe zum Verkleben von Substraten, sowie als photopolymerisierbare Zusammensetzung in der Stereolithographie. Die erfindungsgemäßen Zusammensetzungen können auch zur Herstellung von Lacken durch Photopolymerisation verwendet werden, wobei einerseits klare (transparente) und sogar pigmentierte Zusammensetzungen verwendet werden können. Es können sowohl Weiss- als auch Buntpigmente verwendet werden.

Die erfindungsgemässen Zusammensetzungen zeichnen sich als Schichten auf den Oberflächen von Trägermaterialien durch eine hohe Haftfestigkeit aus. Ferner zeichnen sich die beschichteten Materialien durch eine sehr hohe Oberflächenglätte und -glanz aus. Sie eignen sich hervorragend als Resistmaterialien.

Die erfindungsgemässen photohärtbaren Zusammensetzungen eignen sich besonders zur Herstellung von Schutzschichten und Reliefabbildungen. Ein weiterer Gegenstand der Erfindung ist eine Variante des erfindungsgemäßen Verfahrens zur Herstellung von beschichteten Materialien oder Reliefabbildungen auf Substraten, bei dem man eine erfindungsgemässe Zusammensetzung und gegebenenfalls Lösungsmittel als Schicht auf einem Träger aufbringt, zum Beispiel durch Tauch-, Streich-, Giess-, Walz-, Rakel- oder Schleudergießverfahren, gegebenenfalls das Lösungsmittel entfernt, und die Schicht zur Polymerisation bestrahlt, oder die Schicht durch eine Photomaske bestrahlt und anschliessend die nichtbestrahlten Anteile mit einem Lösungsmittel entfernt. Mit diesem Verfahren können Oberflächen von Substraten modifiziert oder geschützt werden, oder es können zum Beispiel gedruckte Schaltungen, Druckplatten oder Druckwalzen hergestellt werden. Bei der Herstellung von gedruckten Schaltungen können die erfindungsgemäßen Zusammensetzungen auch als Lötstopplacke eingesetzt werden. Weitere Anwendungsmöglichkeiten sind die Herstellung von Siebdruckmasken, die Verwendung als strahlungshärtbare Druckfarben für den Offset-, Sieb- und Flexodruck. Die photopolymerisierbare Schicht kann bei der Bestrahlung mit einer strahlungsdurchlässigen Schutzfolie abgedeckt werden.

Gegenstand der vorliegenden Erfindung ist ferner ein beschichtetes Trägermaterial, das dadurch gekennzeichnet ist, dass auf einem Substrat eine Schicht aus einer erfindungsgemässen Zusammensetzung aufgebracht ist.

Gegenstand der vorliegenden Erfindung ist ebenfalls ein beschichtetes Substrat mit einer kontinuierlichen oder unterbrochenen Schicht eines Polymeren aus gleichen oder verschiedenen nichtflüchtigen radikalisch oder kationisch photopolymerisierbaren oder photovernetzbaren Monomeren, das dadurch gekennzeichnet ist, dass das Polymer Mikropartikel enthält, an die gleiche oder verschiedene Spaltprodukte von Photoinitiatoren, oder Photoinitiatoren und Sensibilisatoren oder Coinitiatoren kovalent gebunden sind.

Geeignete Substrate (Trägermaterialien) sind beispielsweise solche aus Glas, Mineralien, Keramiken, Kunststoffen, Holz, Halbmetallen, Metallen, Metalloxiden und Metallnitriden. Die Schichtdicken richten sich im wesentlichen nach der gewünschten Verwendung und können z.B. 0,1 bis 1000 µm, bevorzugt 0,5 bis 500 µm, besonders bevorzugt 1 bis 100 µm betragen. Die beschichteten Materialien zeichnen sich durch eine hohe Haftfestigkeit und gute thermische und mechanische Eigenschaften aus.

Die Herstellung der erfindungsgemässen beschichteten Materialen kann nach bekannten Methoden wie zum Beispiel Streichen, Rakeln, Giessverfahren wie Vorhanggiessen oder Schleudergiessen erfolgen.

Ein weiterer Gegenstand ist die Verwendung von heterogenen Photoinitiatoren in Form von Mikropartikeln, die aus einem feinteiligen Trägermaterial bestehen, an das gleiche oder verschiedene Photoinitiatoren kovalent gebunden sind, zur strahlungsinduzierten Polymerisation von photopolymerisierbaren oder photovernetzbaren Monomeren.

Die erfindungsgemässen heterogenen Photoinitiatoren zeichnen sich überraschend besonders durch eine höhere Empfindlichkeit und kürzere Reaktionszeiten aus, wobei zusätzlich der Umsatz der Monomeren nach dem Start der Polymerisation in einem wesentlichen kürzeren Zeitraum erfolgt, verglichen mit der gleichen Menge Photoinitiator im homogenen Reaktionsgemisch (Photoinitiator gelöst).

Die folgenden Beispiele erläutern die Erfindung weiter.

### A) Herstellung von heterogenen Photoinitiatoren

### Beispiel A1: Herstellung eines Mikrogels auf Styrolbasis Folgende Komonenten werden verwendet:

96 g (0,92 Mol) Styrol
96 g (0,628 Mol) Vinylbenzylchlorid
8 g (0,062 Mol) Divinylbenzol
16 g (0,058 Mol) α-Hydroxyacetophenon-p-ethoxyacrylsäureester
2,8 g K₂S₂O₈
0,96 gNaHSO₃
10,8 g Natriumlaurylsulfat
672 ml deionisiertes Wasser

Natriumlaurylsulfat und 600 ml deionisiertes Wasser werden in einem Kolben vorgelegt. Man rührt bei 200 Umdrehungen pro Minute, spült mit Stickstoff und erwärmt auf 60 °C. Man gibit 20 ml einer wässrigen Lösung der Monomeren zu. Nach 10 Minuten werden 1,4 g K₂S₂O₈ in 30 ml Wasser gelöst und o,48 g NaHSO₃-Lösung iin 6 ml Wasser zugegeben. Der Rest der Monomeren wird danach langsam während einer Stunde zugegeben. Danach werden die restlichen 1,4 g an K₂S₂O₈ und 0,48 g NaHSO₃ zugefügt und während 3 Stunden gerührt. Man erhält 876,2 g (97 % der Theorie) einer wässrigen Emulsion (Latex).

Zur Charakterisierung werden 100 g der Emulsion mit 5 g MgSO₄ koaguliert. Das isolierte Polymer wird mit deionisiertem Wasser gewaschen und dann im Vakuum getrocknet. Man erhält 24 g Polymer, entsprechend einem Gehalt von der Latex von 24 % (Theorie 24,3 %). Der Chlorgehalt wird mit 9,91 % (Theorie: 10,01 %) bestimmt. Die Grösse der Polymerpartikel in der wässrigen Emulsion wird mittels Quasi-Elastischer-Lichtstreuung bestimmt und beträgt 35-50 nm. Die elektronenmikroskopische Bestimmung der Partikelgrösse ergibt in guter Uebereinstimmung 50 nm.

### Beispiel A2: Quaternisierung

Die gemäss Beispiel A1 erhaltene Latex wird nachträglich mit Dimethylbenzylamin quaternisiert. Man verwendet
500 g Latex gemäss Beispiel A1
47,05 g N,N-Dimethylbenzylamin
620,3 g deionisiertes Wasser
501,15 g Isopropanol

Die angegebene Menge Latex wird in einem Kolben vorgelegt bei 200 U/min und Raumtemperatur eine 1:3-Mischung aus Wasser und Isopropanol bis auf einen Rest von 50 ml zugegeben. N,N.Dimethylbenzylamin wird in diesen 50 ml Lösungsmittel gelöst und während 1,5 Stunden tropfenweise zugegeben. Danach wird 16 Stunden bei Raumtemperatur gerührt. Man erhält eine homogene Dispersion mit einem pH-Wert von 7.

Das erhaltene Produkt wird mit gesättigter NaCI-Lösung koaguliert, abfiltriert, mit deionisiertem Wasser gewaschen und getrocknet. Ausbeute: 159,3 g (95 % der Theorie). Analyse: Cl zu N: 2,41 (Theorie 2,54).

### Beispiel A3: Einführung ungesättigter Gruppen durch Quaternisierung Es werden folgende Bestandteile verwendet:

200 g Latex gemäss Beispiel A1 (24,3 % Feststoffgehalt)
22,01 g 2-Dimethylaminoethyl-methacrylat (DMAM)
273,5 g deionisiertes Wasser
212,4 g Isopropanol.

Eine 1:3-Mischung aus Wasser/Isopropanol wird bis auf eine Restmenge von 50 ml mit der Latex in einem Kolben vorgelegt, bei 200 U/min gerührt, und dann DMMA in 50 ml Wasser/Isopropanol (1:3) während 1,5 Stunden bei Raumtemperatur zugetropft.Danach wird 16 Stunden bei 60 °C weitergerührt. Die erhaltene homogene Emulsion weist einen pH-Wert von 7 auf.
Die Emulsion wird mit 50 ml gesättigter NaCl-Lösung unter Rühren bei 300 U/min während 10 Minuten koaguliert, das Polymer abfiltriert, mit deionisiertem Wasser gewaschen und Vakuum bei 50 °C getrocknet.Ausbeute: 64,13 g (91 % der Theorie). Elementaranalyse Verhältnis Cl zu N: 2,65 (Theorie: 2,54).

### Beispiel A4:

Es werden folgende Komponenten verwendet:
10,5 g Ethylacrylat (0,105 Mol)
1 g Butandioldimethacrylat (0,0044 Mol)
14,5 g Methacrylsäure
24 g α-Hydroxyacetophenon-p-ethoxyacrylsäureester (0.0862 Mol)

0,8 g Natriumdodecylsulfat und 200 ml deionisiertes Wasser werden im Reaktionskolben vorgelegt. Man rührt (etwa 250 U/min), spült mit Stickstoff und erwärmt auf 80 °C. Man gibt den α-Hydroxyacetophenon-p-ethoxyacrylsäureester zu und spült 20 Minuten mit Stickstoff. Dann werden das Ethylacrylat, Butandioldimethacrylat und die Methacrylsäure zugegeben und mit o,5 ml einer 7%-igen wässrigen Na₃PO₄-Lösung versetzt. Man stoppt die Stickstoffzufuhr und homogenisiert die Emulsion während 10 Minuten. Danach gibt man 2 ml einer wässrigen 5%-igen Kaliumpersulfat-Lösung zu. Man polymerisiert 1 Stunde und gibt dann nochmals 2 ml der wässrigen 5%-igen Kaliumpersulfat-Lösung zu. Man erwärmt weitere 3 Stunden bei 80 °C. Dann filtriert man über Glaswolle und erhält 248,5 g Polymerlatex. Das getrocknete Polymer weist eine Glasumwandlungstemperatur von 173 °C auf. Die Emulsion ist 19,3-prozentig.

### Beispiel A5: Quaternisierung der Latex gemäss Beispiel A4

Es werden folgende Bestandteile verwendet:
150 g Latex gemäss Beispiel A4
15,34 g N,N-Dimethylaminoethylmethacrylat (DMAM)
132,9 g Isopropanol
144,8 g deionisiertes Wasser

Die Latex wird in einem Kolben vorgelegt und bei 200 U/min gerührt. Die Mischung aus Wasser und Isopropanol wird bis auf 30 ml zugegeben. In diesen 30 ml wird das DMAM gelöst, tropfenweise zugegeben (während einer Stunde) und dann 6 Stunden bei 60 °C gerührt. Man filtriert über Glaswolle und erhält 418 g.

### B) Anwendungsbeispiele

### Beipiel B1: Herstellung von Reliefabbildungen

Je 100 Gewichtsteile der Polymerpartikel gemäss den Beispielen A1, A2 und A3 werden unter Rühren mit 100 Gewichtsteilen Bispentaerythrol-monohydroxy-pentaacrylat (Sartomer® 399) gleichmässig vermischt. Die Mischungen werden mittels Rakeln als 8 bis 10 µm dicke Filme auf Kupferlaminatplatten aufgetragen und mit einem 8 bis 10 µm dicken Polyvinylalkoholfilm abgedeckt. Man belichtet aus 20 cm Entfernung unter einer Maske (Stouffer-Keil) mit einer UV-Lampe. Man erhält nach der Entwicklung eine festhaftende Reliefabbildung mit sehr guter Auflösung.

### Beispiel B2: Bestimmung der Reaktionsenthalpien

Es werden folgende Formulierungen verwendet:

| Formulierung A | Formulierung B |
|---|---|
| 54,4 g Hydroxyethylmethacrylat | 50 g Hydroxyethylmethacrylat |
| 50,0 g Butandioldiacrylat | 50 g Butandioldiacrylat |
| 8,09 α-Hydroxyacetophenon (Irgacure® 2959) | 32 g Latex von Beispiel A5 |
| 307,51 ml Wasser/Isopropanol (2:1) | 288 ml Wasser/Isopropanol (2:1) |

Beide Formulierungen (4,3 g, 30-prozentig in Wasser/Isopropanol)) enthalten die gleichen Mengen an Doppelbindungen (2,19x10⁻³ Mol/g) und Photoinitiator. Mittels Differential-Scanning-Calometrie wird der Verlauf der Polymerisation durch Bestrahlung mit einem He/Cd-Laser bei 325 nm durch die isotherme Messung der Wärmeentwicklung in Abhängigkeit von der Zeit gemessen. Bei dem Vergleich ist zu berücksichtigen, dass nur an der Oberfläche der Mikropartikel gebundene Photoinitiatoren wirksam sein können. Ergebnis:

| | Reaktionspeak nach Minuten | Reaktionsenthalpie nach 6 Minuten |
|---|---|---|
| Formulierung A | 5,73 | 41,9 % |
| Formulierung B | 3,67 | 88,9 % |

## Patentansprüche

1. Heterogener Photoinitiator in Form von Mikropartikeln mit einer mittleren Teilchengrösse von 2 bis 1000 nm, der aus einem feinteiligen Trägermaterial besteht, an das gleiche oder verschiedene Photoinitiatoren kovalent gebunden sind und bei dem es sich um ein Polymerisat handelt, an dessen Rückgrat monovalente Reste der Photoinitiatoren direkt oder über eine Brückengruppe kovalent gebunden sind, wobei das Polymerisat mindestens ein Strukturelement der Formel XI enthalten, 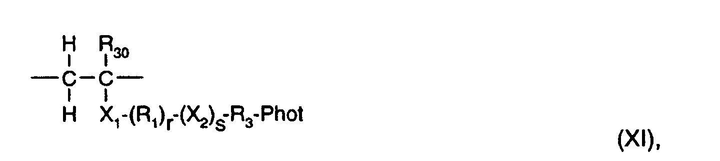 worin
R₃₀ H oder Methyl bedeutet,
X₁ und X₂ unabhängig voneinander eine direkte Bindung, oder X₂ und X₁ zusammen unabhängig voneinander -O-, -S-, -NR₂-, -C(O)-O-, -O-C(O)-, -O-C(O)-O-, -SO₂-O-, -O-SO₂-, -O-SO₂-O-, -NR₂-C(O)-, -C(O)-NR₂-, -NR₂-C(O)-O-, -O-C(O)-NR₂-, -NR₂-C(O)-NR₂-, -NR₂-SO₂-, -SO₂-NR₂-, -NR₂-SO₂-O-, -O-SO₂-NR₂- oder -NR₂-SO₂-NR₂- bedeuten,
R₁ eine bivalente Brückengruppe darstellt,
Phot für einen monovalenten Rest eines Photoinitiators steht,
R₃ eine direkte Bindung, C₁-C₁₈-Alkylen, C₅- oder C₆-Cycloalkylen, C₆-C₁₀-Arylen oder C₇-C₁₂-Aralkylen bedeutet,
r die Zahlen 0 oder 1 und s die Zahlen 0 oder 1 bedeuten, sowie s für die Zahl 0 steht, wenn r die Zahl 0 darstellt, und
das Polymerisat mit gleichen oder verschiedenen Strukturelementen der Formeln XIV oder XV vernetzt ist, 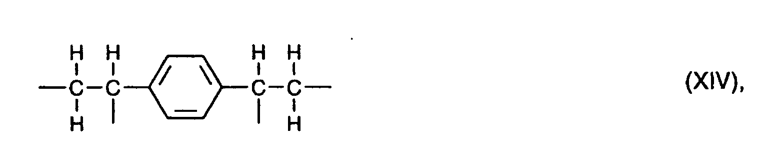 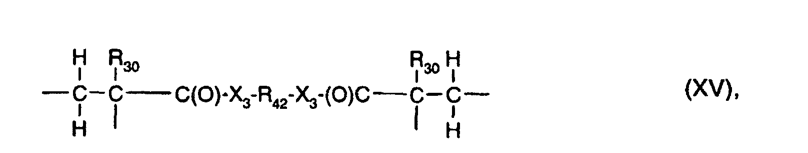 worin
R₃₀ H oder Methyl bedeutet,
X₃ für -O- oder -NH- oder -N(C₁-C₄-Alkyl)- steht, und
R₄₂ C₂-C₁₂- und bevorzugt C₁-C₆-Alkylen, Cyclohexylen, Cyclohexylendimethylen oder X₃ für -O- steht und R₄₂ C₂-C₆-Alkylen-(C₂-C₆-Alkylen-O)_{2 bis 20}- C₂-C₆-Alkylen-darstellt.

2. Photoinitiator gemäss Anspruch 1, **dadurch gekennzeichnet, dass** die Gruppe -X₁-(R₁)ᵣ-(X₂)ₛ-R₃- in den Strukturelementen der Formel Xl für-C(O)-O-, -C(O)-O-C₁-C₆-Alkylen-O-, -C(O)-O-(C₂-C₆-Alkylen-O)ᵤ- mit u gleich einer Zahl von 2 bis 10, -C(O)-O-(C₂-C₆-Alkylen-O)ᵤ-C₁-C₆-Alkylen- mit u gleich einer Zahl von 2 bis 10, und -C(O)-O-C₁-C₆-Alkylen-S- steht.

3. Photoinitiator gemäss einem der Ansprüche 1 oder 2, **dadurch gekennzeichnet, dass** der Rest Phot den Formeln 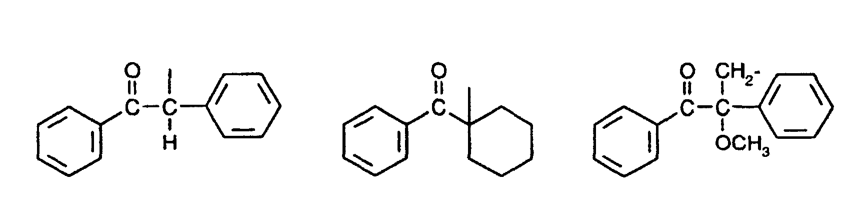 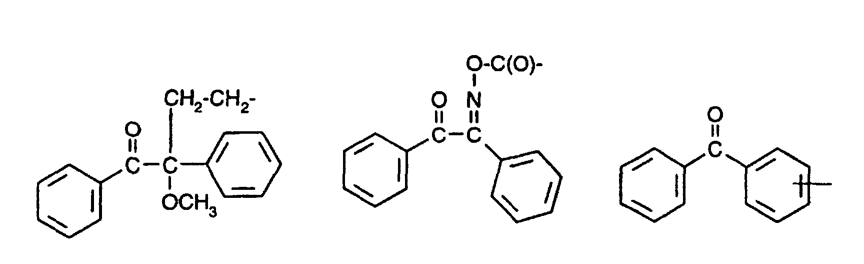 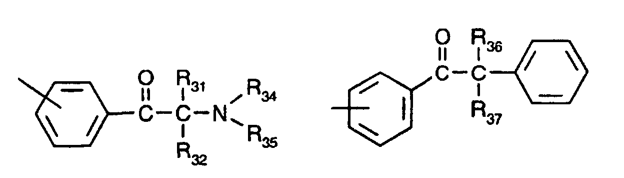 entspricht, worin
R₃₁ und R₃₂ unabhängig voneinander C₁-C₆-Alkyl, C₃-C₆-Alkenyl, C₅- oder C₆-Cycloalkyl,
C₇-C₁₂-Aralkyl, oder R₃₁ und R₃₂ zusammen Tetra- oder Pentamethylen bedeuten, R₃₄ und R₃₅ unabhängig voneinander C₁-C₁₂-Alkyl, C₅- oder C₆-Cycloalkyl, C₇-C₁₂- sind, oder R₃₄ und R₃₅ zusammen Tetramethylen, Pentamethylen, -CH₂CH₂-O-CH₂CH₂- oder
-CH₂CH₂-N(C₁-C₄-Alkyl)-CH₂CH₂- darstellen, und R₃₆ und R₃₇, unabhängig voneinander C₁-C₆-Alkoxy, C₅- oder C₆-Cycloalkoxy, Phenyloxy oder Phenyl-C₁-C₄-Alkoxy bedeuten, oder R₃₆ und R₃₇ zusammen für C₂-C₄-Alkylendioxyl oder C₂-C₄-Alkenylendioxyl stehen.

4. Photoinitiator gemäss einem der Ansprüche 1 bis 3, **dadurch gekennzeichnet, dass** das Polymerisat neben den Strukturelementen der Formel XI auch gleiche oder verschiedene Strukturelemente der Formel XII enthält, 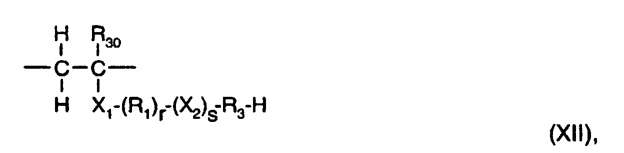 worin
R₃₀, X₁, X₂, R₁, R₃, r und s die in Anspruch 1 angegebenenen Bedeutungen haben.

5. Photoinitiator gemäss einem der Ansprüche 1 bis 4, **dadurch gekennzeichnet, dass** das Polymerisat neben den Strukturelementen der Formel XI auch gleiche oder verschiedene Strukturelemente der Formel XIII enthält, 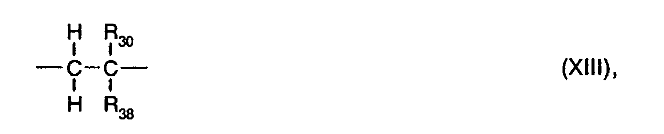 worin
R₃₀ H oder Methyl darstellt, und
R₃₈ H, C₁-C₄-Alkyl, C₁-C₄-Alkoxy, -CN, Cl, Phenyl, Pyrrolidonyl, Pyridinyl, Imidazolyl, -C(O)OR₃₉ oder -C(O)-NR₄₀R₄₁ darstellen,
R₃₉ H oder C₁-C₁₈- und bevorzugt C₁-C₁₂-Alkyl bedeutet, und
R₄₀ und R₄₁ unabhängig voneinander H oder C₁-C₁₂- und bevorzugt C₁-C₆-Alkyl darstellen.

6. Photoinitiator gemäss einem der Ansprüche 1 bis 5, **dadurch gekennzeichnet, dass** das Polymerisat mit den Strukturelementen der Formel XI sowie der Formel XIV und/oder XV und gegebenenfalls Strukturelementen der Formeln XII, XIII zusätzlich gleiche oder verschiedene Strukturelemente enthält, die ionogene Gruppen in Seitenketten gebunden enthalten.

7. Photoinitiator gemäss einem der Ansprüche 1 bis 6, **dadurch gekennzeichnet, dass** das Polymerisat mit den Strukturelementen der Formel XI sowie XIV und/oder XV und gegebenenfalls Strukturelementen der Formeln XII, XIII zusätzlich gleiche oder verschiedene Strukturelemente der Formeln XVIII und XIX enthält, 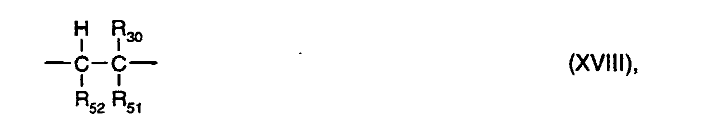 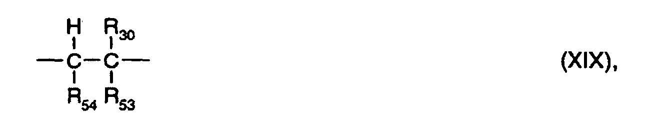 worin
R₃₀ für H oder Methyl steht,
R₅₂ H bedeutet und R₅₁ -C(O)OH, -SO₃H, -C₆H₄-COOH, -C₆H₄-SO₃H darstellt, oder
R₅₁ und R₅₂ -C(O)OH darstellen,
R₅₄ H und R₅₃ Pyridinyl, Imidazolyl, Pyrrolidonyl, -C₆H₄-R₅₅ oder -C(O)-X₄-C₂-C₆-Alkylen-R₅₆ darstellt, oder
R₅₃ und R₅₄ unabhängig voneinander -C(O)-X₄-C₂-C₆-Alkylen-R₅₆ darstellen, und
X₄ für -O-, -NH- oder -N(C₁-C₄-Alkyl) steht,
R₅₅ eine Amingruppe oder eine Aminomethylgruppe darstellt, und
R₅₆ eine Amingruppe bedeutet.

8. Photoinitiator gemäss einem der Ansprüche 1 bis 7, **dadurch gekennzeichnet, dass** das Polymerisat mit den Strukturelementen der Formel XI sowie XIV und/oder XV und gegebenenfalls Strukturelementen der Formeln XII, XIII, zusätzlich gleiche oder verschiedene Strukturelemente der Formel XXI enthält 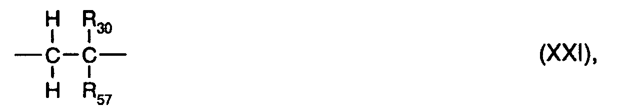 worin
R₃₀ für H oder Methyl steht, und
R₅₇-C₆H₄-CH₂Cl, -C₆H₄-CH₂Br, -C₆H₄-CH₂CH₂Cl, -C₆H₄-CH₂CH₂Br, -C(O)-X₄-C₂-C₆-AlkylenCl, -C(O)-X₄-C₂-C₆-Alkylen-Br, Pyridinyl, Imidazolyl, Pyrrolidonyl, -C₆H₄-R₅₅ oder -C(O)-X₄-C₂-C₆-Alkylen-R₅₆ bedeutet,
R₅₅ eine Amingruppe oder eine Aminomethylgruppe darstellt
R₅₆ eine Amingruppe bedeutet, und
X₄ für -O-, -NH- oder -N(C₁-C₄-Alkyl)- steht.

9. Photoinitiator gemäss einem der Ansprüche 1 bis 8, **dadurch gekennzeichnet, dass** das Polymerisat zusätzlich gleiche oder verschiedene Strukturelemente mit kovalent gebundenen Sensibilisatoren oder Coinitiatoren der Formel XXII enthält, 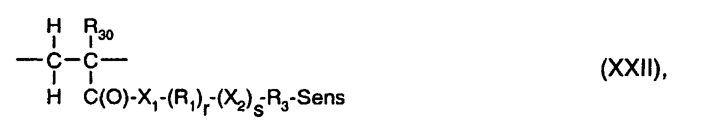 worin
R₃₀ für H oder Methyl steht,
R₁, R₃, X₁, X₂, r und s die in Anspruch 1 angegebenen Bedeutungen haben, und Sens einen Rest der Formel XXIII darstellt, 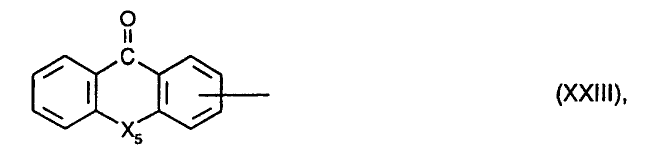 worin
X₅ für -O- und bevorzugt für -S- steht.

10. Photopolymerisierbare und/oder photovernetzbare Zusammensetzung, enthaltend (a) gleiche oder verschiedene nichtflüchtige radikalisch oder kationisch photopolymerisierbare oder photovernetzbare Monomere, und (b) einen heterogenen Photoinitiator gemäss einem der Ansprüche 1 bis 9.

11. Photopolymerisierbare Zusammensetzung gemäss Anspruch 10, **dadurch gekennzeichnet, dass** der Photoinitiator in einer Menge von 0,001 bis 90 Gew.-% enthalten ist, bezogen auf die Zusammensetzung.

12. Photopolymerisierbare Zusammensetzung gemäss einem der Ansprüche 10 oder 11, **dadurch gekennzeichnet, dass** das Monomer wenigstens eine polymerisierbare ethylenisch ungesättigte Gruppe enthält.

13. Photopolymerisierbare Zusammensetzung gemäss Anspruch 12, **dadurch gekennzeichnet, dass** das Monomer ausgewählt ist aus der Gruppe der substituierten Olefine.

14. Photopolymerisierbare Zusammensetzung gemäss Anspruch 13, **dadurch gekennzeichnet, dass** das substituierte Olefin ausgewählt ist aus der Gruppe der Acryl- und Methacrylsäureester und -amide.

15. Photopolymerisierbare Zusammensetzung gemäss Anspruch 12, **dadurch gekennzeichnet, dass** zusätzlich mindestens diethylenisch ungesättigte organische Verbindungen enthalten sind.

16. Photopolymerisierbare Zusammensetzung gemäss Anspruch 15, **dadurch gekennzeichnet, dass** die Menge der mindestens diethylenisch ungesättigten organischen Verbindungen wenigstens 0,1 Gew.-% beträgt, bezogen auf die Monomeren.

17. Photopolymerisierbare Zusammensetzung gemäss Anspruch 14, **dadurch gekennzeichnet, dass** es sich bei den Acryl- und Methacrylsäureestern und -amiden um solche der Formel XXIV handelt, 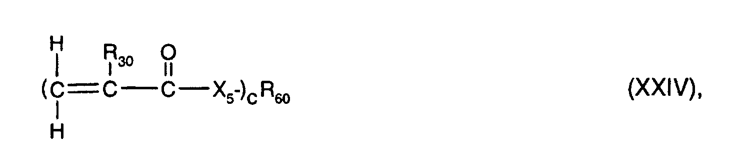 worin
R₃₀ H oder Methyl bedeutet,
c für eine Zahl von 1 bis 8 steht,
X₅ die Gruppen -O-, -NH- oder -N(C₁-C₄-Alkyl)- darstellt, und
R₆₀ einen monovalenten bis octavalenten Kohlenwasserstoffrest mit 1 bis 50 C-Atomen bedeutet.

18. Photopolymerisierbare Zusammensetzung gemäss einem der Ansprüche 10 bis 17, **dadurch gekennzeichnet, dass** sie als Formulierungshilfstoffe Lösungsmittel, Antioxidantien, Lichtschutzmittel, Weichmacher, Farbstoffe, Pigmente, Füllstoffe, Verstärkerfüllstoffe, Gleitmittel, Tenside und/oder Entformungshilfsmittel enthält.

19. Verfahren zur Herstellung von Formkörpern, Beschichtungen, Reliefabbildungen oder Reliefstrukturen, durch Einwirkung von aktinischer Strahlung auf eine polymerisierbare Zusammensetzung gemäss einem der Ansprüche 10 bis18.

## Claims

1. Heterogeneous photoinitiator in the form of microparticles having a mean particle size of from 2 to 1000 nm, which consists of a finely divided substrate material to which identical or different photoinitiators are covalently bonded and comprises a polymer to whose backbone monovalent radicals of identical or different photoinitiators are covalently bonded, directly or by way of a bridging group, the polymer comprising at least one structural unit of the formula XI, 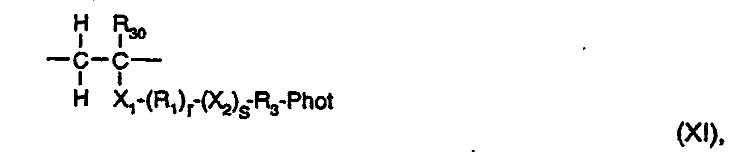 in which R₃₀ is H or methyl,
X₁ and X₂ independently of one another are a direct bond, or X₂ and X₁ together independently of one another are -0-, -S-, -NR₂-, -C(0)-0-, -0-C(0)-, -0-C(0)-0-, -S0₂-0-, -0-SO₂-, -0-S0₂-0-, -NR₂-C(O)-, -C(O)-NR₂-, -NR₂-C(0)-0-, 0-C(0)-NR₂-, -NR2-C(O)-NR₂-, -NR₂-S0₂-, -S0₂-NR₂-, -NR₂-S0₂-O-, 0-S0₂-NR₂- or -NR₂-S0₂-NR₂-,
R₁ is a bivalent bridging group,
Phot is a monovalent radical of a photoinitiator,
R₃ is a direct bond, C₁-C₁₈alkylene, C₅- or C₆cycloalkylene, C₆-C₁₀arylene or C₇-C₁₂aralkylene,
r is the number 0 or 1 and s is the number 0 or 1, and s is 0 if r is 0, and the polymer is crosslinked with identical or different structural units of the formulae XIV or XV, 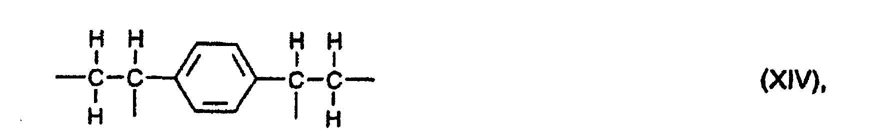 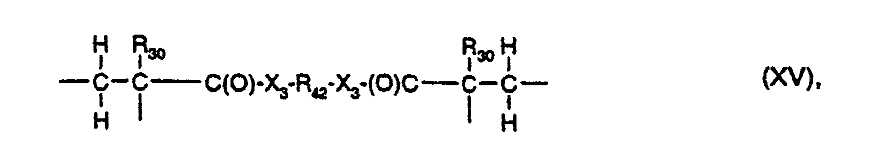 in which
R₃₀ is H or methyl,
X₃ is -0- or -NH- or -N(C₁-C₄alkyl)-, and
R₄₂ is C₂-C₁₂- and preferably C₁-C₆alkylene, cyclohexylene, cyclohexylenedimethylene or X₃ is -0- and R₄₂ is C₂-C₆alkylene- (C₂-C₆alkylene-O)_{2 to 20} -C₂-C₆alkylene-.

2. Photoinitiator according to claim 1, **characterized in that** the group -X₁-(R₁)ᵣ(X₂)ₛ-R₃- in the structural units of the formula XI is -C(0)-O-, -C(0)-0-C₁-C₆alkylene-0-, -C(0)-0-(C₂-C₆alkylene-0)ᵤ- where u is equal to a number from 2 to 10, C(0)-O-(C₂-C₆alkylene-0)ᵤ-C₁-C₆alkylene- where u is a number from 2 to 10 and -C(0)-0-C₁-C₆alkylene-S-.

3. Photoinitiator according to either of claims 1 and 2, **characterized in that** the radical Phot conforms to the formulae 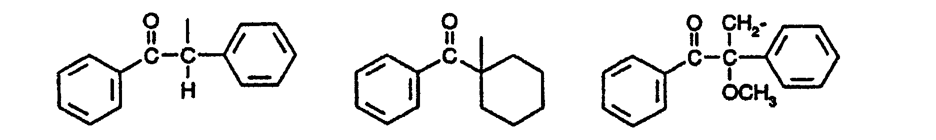 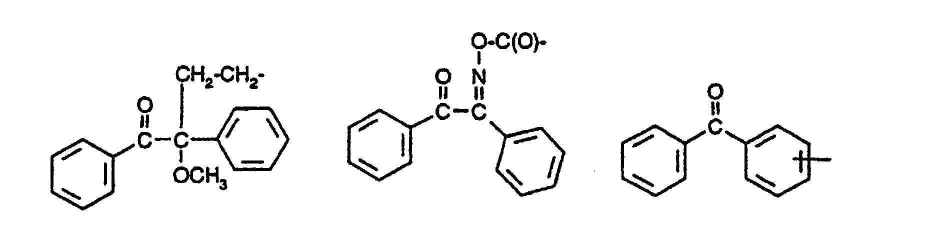 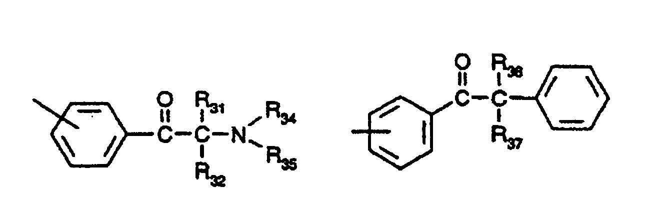 in which
R₃₁ and R₃₂ independently of one another are C₁-C₆alkyl, C₃-C₆alkenyl, C₅- or C₆cycloalkyl, C₇-C₁₂aralkyl, or R₃₁ and R₃₂ together are tetra- or pentamethylene, R₃₄ and R₃₅ independently of one another are C₁-C₁₂alkyl, C₅- or C₆cycloalkyl, C₇-C₁₂aralkyl, or R₃₄ and R₃₅ together are tetramethylene, pentamethylene, -CH₂CH₂-O-CH₂CH₂ or -CH₂CH₂-N(C₁-C₄alkyl)-CH₂CH₂-, and R₃₆ and R₃₇ independently of one another are C₁-C₆alkoxy, C₅- or C₆cycloalkoxy, phenyloxy or phenyl-C₁-C₄alkoxy, or R₃₆ and R₃₇ together are C₂-C₄alkylenedioxyl or C₂-C₄alkenylenedioxyl.

4. Photoinitiator according to any of claims 1 to 3, **characterized in that** the polymer in addition to the structural units of the formula XI also comprises identical or different structural units of the formula XII, 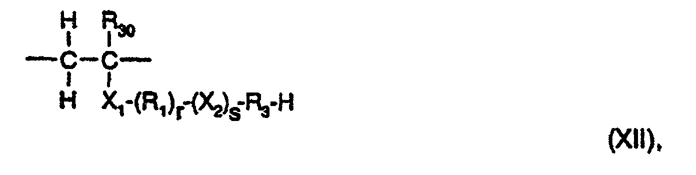 in which
R₃₀, X₁, X₂, R₁, R₃, r and s are as defined in claim 1.

5. Photoinitiator according to any of claims 1 to 4, **characterized in that** the polymer in addition to the structural units of the formula XI also comprises identical or different structural units of the formula XIII, 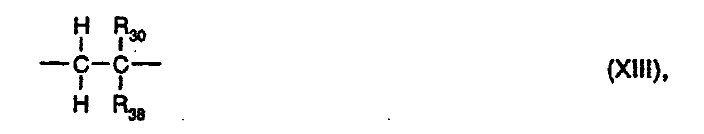 in which
R₃₀ is H or methyl, and
R₃₈ is H, C₁-C₄alkyl, C₁-C₄alkoxy, -CN, Cl, phenyl, pyrrolidonyl, pyridinyl, imidazolyl,
-C(O)OR₃₉ or -C(O)-NR₄₀R₄₁,
R₃₉ is H or C₁-C₁₈- and preferably C₁-C₁₂alkyl, and
R₄₀ and R₄₁ independently of one another are H or C₁-C₁₂- and preferably C₁-C₆alkyl.

6. Photoinitiator according to any of claims 1 to 5, **characterized in that** the polymer with the structural units of the formula XI and of the formula XIV and/or XV and, if desired, structural units of the formulae XII, XIII in addition comprises identical or different structural units containing ionogenic groups attached in side chains.

7. Photoinitiator according to any of claims 1 to 6, **characterized in that** the polymer having the structural units of the formula XI and XIV and/or XV and, if desired, structural units of the formulae XII, XIII in addition comprises identical or different structural units of the formulae XVIII and XIX, 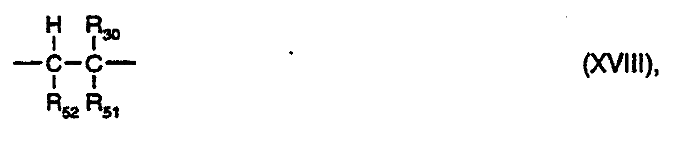 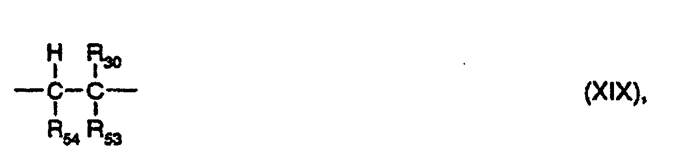 in which
R₃₀ is H or methyl,
R₅₂ is H and R₅₁ is -C(O)OH, -SO₃H, -C₆H₄-COOH, -C₆H₄-SO₃H, or
R₅₁ and R₅₂ are -C(O)OH,
R₅₄ is H and R₅₃ is pyridinyl, imidazolyl, pyrrolidonyl, -C₆H₄-R₅₅ or -C(O)-X₄-C₂-C₆alkylene-R₅₆, or
R₅₃ and R₅₄ independently of one another are -C(O)-X₄-C₂-C₆alkylene-R₅₆, and
X₄ is -0-, -NH- or -N(C₁-C₄alkyl),
R₅₅ is an amine group or an aminomethyl group, and
R₅₆ is an amine group.

8. Photoinitiator according to any of claims 1 to 7, **characterized in that** the polymer having the structural units of the formula XI and XIV and/or XV and, if desired, structural units of the formulae XII, XIII, in addition comprises identical or different structural units of the formula XXI 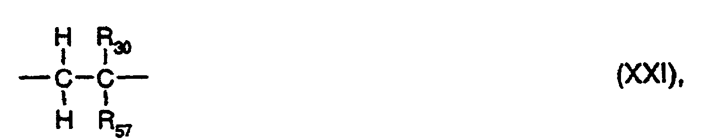 in which
R₃₀ is H or methyl, and
R₅₇ is -C₆H₄-CH₂Cl, -C₆H₄-CH₂Br, -C₆H₄-CH₂CH₂Cl, -C₆H₄-CH₂CH₂Br, -C(O)-X₄-C₂-C₆alkyleneCl, -C(O)-X₄-C₂-C₆alkylene-Br, pyridinyl, imidazolyl, pyrrolidonyl, -C₆H₄-R₅₅ or -C(O)-X₄-C₂-C₆alkylene-R₅₆,
R₅₅ is an amine group or an aminomethyl group,
R₅₆ is an amine group, and
X₄ is -0-, -NH- or -N(C₁-C₄alkyl)-.

9. Photoinitiator according to any of claims 1 to 8, **characterized in that** the polymer in addition comprises identical or different structural units with covalently bonded sensitizers or coinitiators of the formula XXII, 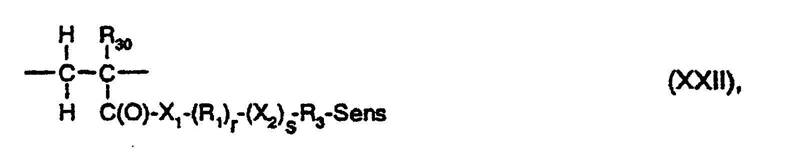 in which
R₃₀ is H or methyl,
R₁, R₃, X₁, X₂, r and s are as defined in claim 1, and Sens is a radical of the formula XXIII, 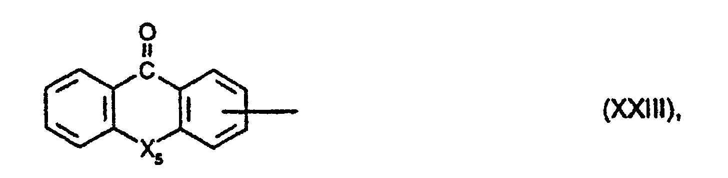 in which
X₅ is -0- and preferably is -S-.

10. Photopolymerizable and/or photocrosslinkable composition comprising (a) identical or different nonvolatile free-radically or cationically photopolymerizable or photocrosslinkable monomers and (b) a heterogeneous photoinitiator according to any of claims 1 to 9.

11. Photopolymerizable composition according to claim 10, **characterized in that** the photoinitiator is present in an amount of from 0.001 to 90% by weight, based on the composition.

12. Photopolymerizable composition according to either of claims 10 and 11, **characterized in that** the monomer comprises at least one polymerizable ethylenically unsaturated group.

13. Photopolymerizable composition according to claim 12, **characterized in that** the monomer is selected from the group of the substituted olefins.

14. Photopolymerizable composition according to claim 13, **characterized in that** the substituted olefin is selected from the group of the acrylic and methacrylic esters and amides.

15. Photopolymerizable composition according to claim 12, **characterized in that** at least diethylenically unsaturated organic compounds are additionally present.

16. Photopolymerizable composition according to claim 15, **characterized in that** the amounts of the at least diethylenically unsaturated organic compounds is at least 0.1% by weight, based on the monomers.

17. Photopolymerizable composition according to claim 14, **characterized in that** the acrylic and methacrylic esters and amides are those of the formula XXIV, 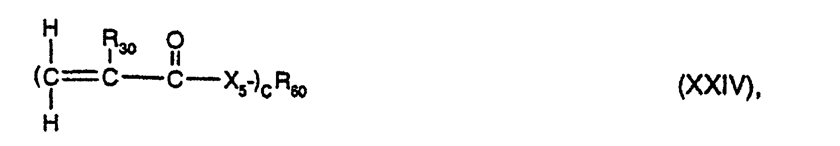 in which
R₃₀ is H or methyl,
c is a number from 1 to 8,
X is the groups -0-, -NH- or -N(C₁-C₄alkyl)-, and
R₆₀ is a monovalent to octavalent hydrocarbon radical having 1 to 50 C atoms.

18. Photopolymerizable composition according to any of claims 10 to 17, **characterized in that** it comprises as formulating auxiliaries solvents, antioxidants, light stabilizers, plasticizers, dyes, pigments, fillers, including reinforcing fillers, lubricants, surfactants and/or mold release auxiliaries.

19. Process for producing mouldings, coatings, relief images or relief structures, by exposure to actinic radiation of a polymerizable composition according to any of claims 10 to 18.

## Revendications

1. Photoamorceur hétérogène sous la forme de microparticules avec une grosseur de particule moyenne de 2 à 1000 nm, qui est constitué d'un substrat à fines particules auquel des photoamorceurs identiques ou différents sont liées par covalence et pour lequel il s'agit d'un polymérisat sur le squelette duquel des restes monovalents des photoamorceurs sont liés par covalence directement ou via un groupe pontant, le polymérisat comprenant au moins un élément structurel de formule XI, 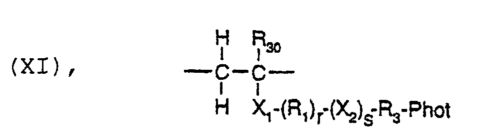 où
R₃₀ représente H ou méthyle,
X₁ et X₂, représentent, indépendamment l'un de l'autre, une liaison directe, ou X₂ et X₁ représentent ensemble, indépendamment l'un de l'autre, -O-, -S-, -NR₂-, -C(O)-O-, -O-C(O)-, -O-C(O)-O-, -SO₂-O-, -O-SO₂-, -O-SO₂-O-, NR₂-C(O), -C(O)-NR₂-, -NR₂-C(O)-O-, O-C(O)-NR₂-, -NR₂-C(O)-NR₂-, -NR₂-SO₂-, -SO₂-NR₂-, -NR₂-SO₂-O-, -O-SO₂-NR₂- ou -NR₂-SO₂-NR₂-,
R₁ représente un groupe pontant bivalent,
Phot représente le reste monovalent d'un photoamorceur,
R₃ représente une liaison directe, C₁-C₁₈-alkylène, C₅- ou C₆-cycloalkylène, C₆-C₁₀-arylène ou C₇-C₁₂-aralkylène,
r représente les nombres 0 ou 1 et s les nombres 0 ou 1, de sorte que s représente le nombre 0 lorsque r représente le nombre 0, et
le polymérisat est réticulé avec des éléments structurels identiques ou différents de formules XIV ou XV, 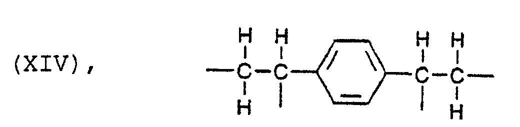 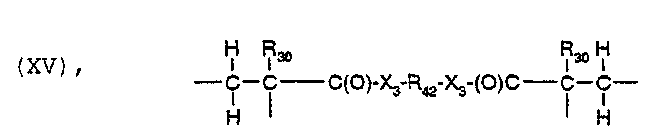 où
R₃₀ représente H ou méthyle,
X₃ représente -O- ou -NH- ou -N(C₁-C₄-alkyle) et
R₄₂ représente C₂-C₁₂-alkylène et de manière préférentielle, C₁-C₆-alkylène, cyclohexylène, cyclohexylènediméthylène ou X₃ représente -O- et R₄₂ représente C₂-C₆-alkylène-(C₂-C₆-alkylène-O)_{2 à 20}- C₂-C₆-alkylène.

2. Photoamorceur selon la revendication 1, **caractérisé en ce que** le groupe -X₁-(R₁)ᵣ -(X₂)ₛ -R₃ représente, dans les éléments structurels de formule XI, -C(O)-O-, -C(O)-O-C₁-C₆-alkylène-O-, -C(O)-O-(C₂-C₆-alkylène-O)ᵤ, u étant égal à un nombre de 2 à 10, -C(O)-O-(C₂-C₆-alkylène-O)ᵤ-C₁-C₆-alkylène, u étant égal à un nombre de 2 à 10, et -C(O)-O-C₁-C₆-alkylène-S.

3. Photoamorceur selon une des revendications 1 ou 2, **caractérisé en ce que** le reste Phot correspond aux formules 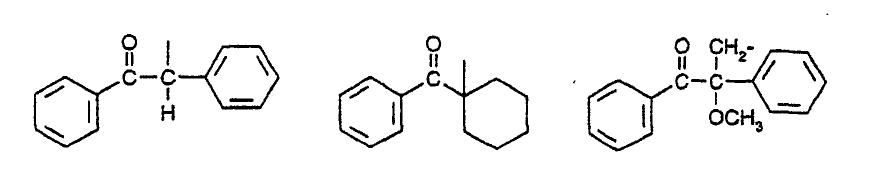 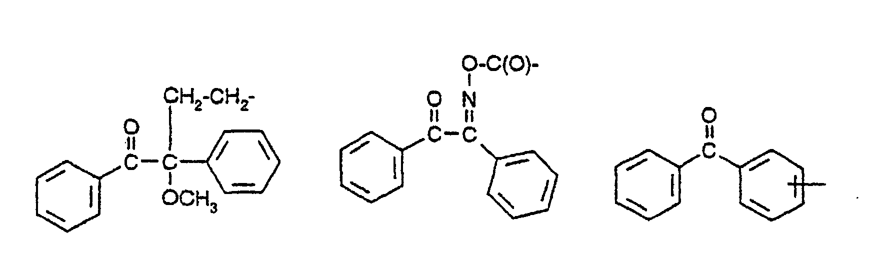 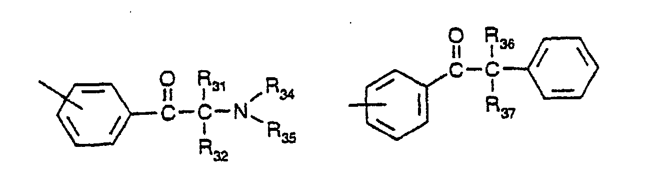 où
R₃₁ et R₃₂ représentent, indépendamment l'un de l'autre, C₁-C₆-alkyle, C₃-C₆-alkényle, C₅- ou C₆-cycloalkyle, C₇-C₁₂-aralkyle, ou R₃₁ et R₃₂ représentent ensemble tétra- ou pentaméthylène, R₃₄ et R₃₅ représentent, indépendamment l'un de l'autre, C₁-C₁₂ alkyle, C₅- ou C₆-cycloalkyle, C₇-C₁₂-aralkyle, ou R₃₄ et R₃₅ représentent ensemble tétraméthylène, pentaméthylène, -CH₂CH₂-O-CH₂CH₂- ou -CH₂CH₂-N(C₁-C₄-alkyle)-CH₂CH₂- et R₃₆ et R₃₇, représentent, indépendamment l'un de l'autre, C₁-C₆-alcoxy, C₅- ou C₆-cycloalcoxy, phényloxy- ou phényl-C₁-C₄-alcoxy, ou R₃₆ et R₃₇ représentent ensemble C₂-C₄-alkylendioxyle ou C₂-C₄-alkenylènedioxyle.

4. Photoamorceur selon une des revendications 1 à 3, **caractérisé en ce que** le polymérisat, outre les éléments structurels de formule XI, contient également des éléments structurels identiques ou différents de formule XII, 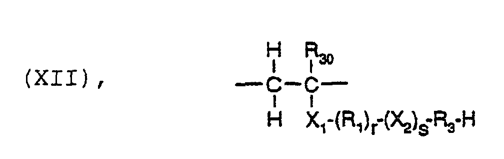 où
R₃₀, X₁, X₂, R₁, R₃, r et s ont les significations indiquées dans la revendication 1.

5. Photoamorceur selon une des revendications 1 à 4, **caractérisé en ce que** le polymérisat comprend, outre les éléments structurels de formule XI également des éléments structurels identiques ou différents de formule XIII, 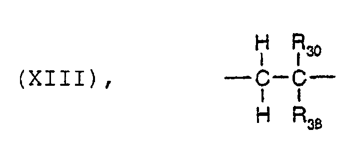 où
R₃₀ représente H ou méthyle et
R₃₈ représente H, C₁-C₄-alkyle, C₁-C₄-alcoxy, -CN, Cl, phényle, pyrrolidonyle, pyridinyle, imidazolyle, C(O)OR₃₉ ou -C(O)-NR₄₀R₄₁,
R₃₉ représente H ou C₁-C₁₈ et, de manière préférentielle, C₁-C₁₂-alkyle et
R₄₀ et R₄₁ représentent, indépendamment l'un de l'autre, H ou C₁-C₁₂ et, de manière préférentielle, C₁-C₆-alkyle.

6. Photoamorceur selon une des revendications 1 à 5, **caractérisé en ce que** le polymérisat contient, avec les éléments structurels de formule XI ainsi que de formule XIV et/ou XV et, le cas échéant, des éléments structurels de formules XII, XIII, en outre des éléments structurels identiques ou différents, qui comprennent des groupes ionogènes liés dans des chaînes latérales.

7. Photoamorceur selon une des revendications 1 à 6, **caractérisé en ce que** le polymérisat contient, avec les éléments structurels de formules XI ainsi que de formules XIV et/ou XV et, le cas échéant, des éléments structurels de formules XII, XIII, en outre des éléments structurels identiques ou différents de formules XVIII et XIX, 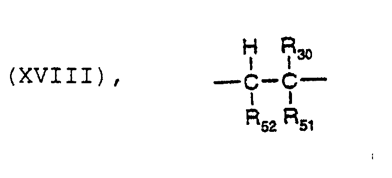 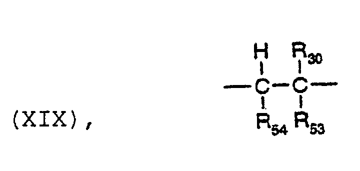 où
R₃₀ représente H ou méthyle,
R₅₂ représente H et R₅₁ représente -C(O)OH, -SO₃H, -C₆H₄-COOH, -C₆H₄-SO₃H, ou
R₅₁ et R₅₂ représentent -C(O)OH,
R₅₄ représente H et R₅₃ représente pyridinyle, imidazolyle, pyrrolidonyle, -C₆H₄-R₅₅ ou -C(O)-X₄-C₂-C₆-alkylène-R₅₆, ou R₅₃ et R₅₄ représentent, indépendamment l'un de l'autre, -C(O)-X₄-C₂-C₆-alkylène-R₅₆, et
X₄ représente -O-, -NH- ou -N(C₁-C₄-alkyle),
R₅₅ représente un groupe amine ou un groupe aminométhyle et R₅₆ représente un groupe amine.

8. Photoamorceur selon une des revendications 1 à 7, **caractérisé en ce que** le polymérisat contient avec les éléments structurels de formules XI à XIV et/ou XV et, le cas échéant, des éléments structurels de formules XII, XIII, des éléments structurels identiques ou différents de formule XXI, 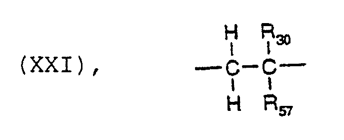 où
R₃₀ représente H ou méthyle, et
R₅₇ représente -C₆H₄-CH₂Cl, -C₆H₄-CH₂Br, -C₆H₄-CH₂CH₂Cl, -C₆H₄-CH₂CH₂Br, -C(O)-X₄-C₂-C₆-alkylèneCl, -C(O)-X₄-C₂-C₆-alkylène-Br, pyridiriyle, imidazolyle, pyrrolidonyle, -C₆H₄-R₅₅ ou -C(O)-X₄-C₂-C₆-alkylène-R₅₆, R₅₅ représente un groupe amine ou aminométhyle, et
R₅₆ représente un groupe amine,
X₄ représente -O-, -NH- ou -N(C₁-C₄-alkyle).

9. Photoamorceur selon une des revendications 1 à 8, **caractérisé en ce que** le polymérisat contient en outre des éléments structurels identiques ou différents avec des sensibilisateurs liés de manière covalente ou des coamorceurs de formule XXII, 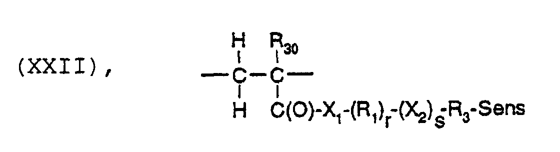 où
R₃₀ représente H ou méthyle,
R₁, R₃, X₁, X₂, r et s ont les significations indiquées dans la revendication 1, et
Sens représente un reste de formule XXIII, 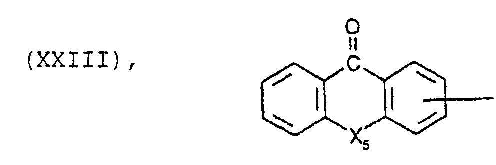 où
X₅ représente -O- et de manière préférentielle -S-.

10. Composition photopolymérisable et/ou photoréticulable contenant (a) des monomères photopolymérisables ou photoréticulables de manière radicalaire ou cationique, non volatils, identiques ou différents et (b) un photoamorceur hétérogène selon une des revendications 1 à 9.

11. Composition photopolymérisable selon la revendication 10, **caractérisée en ce que** le photoamorceur est contenu en une quantité de 0,001 à 90% en poids, rapportée à la composition.

12. Composition photopolymérisable selon une des revendications 10 ou 11, **caractérisée en ce que** le monomère comprend au moins un groupe non saturé éthylénique polymérisable.

13. Composition photopolymérisable selon la revendication 12, **caractérisée en ce que** le monomère est sélectionné à partir du groupe des oléfines substituées.

14. Composition photopolymérisable selon la revendication 13, **caractérisée en ce que** l'oléfine substituée est sélectionnée à partir du groupe des esters et amides de l'acide acrylique et de l'acide méthacrylique.

15. Composition photopolymérisable selon la revendication 12, **caractérisée en ce que**, en outre, au moins des composés organiques non saturés diéthyléniques sont contenus.

16. Composition photopolymérisable selon la revendication 15, **caractérise en ce que** la quantité de composés organiques non saturés diéthyléniques comprend au moins 0,1% en poids, rapportée aux monomères.

17. Composition photopolymérisable selon la revendication 14, **caractérisée en ce que** les esters et les amides de l'acide acrylique et de l'acide méthacrylique correspondent à ceux de formule XXIV, 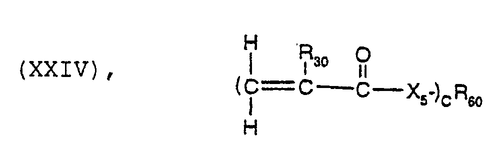 où
R₃₀ représente H ou méthyle,
c représente un nombre de 1 à 8,
X₅ représente les groupes -O-, -NH- ou -N(C)₁-C₄-alkyle)- et R₆₀ désigne un reste d'hydrocarbure monovalent à octavalent avec 1 à 50 atomes de carbone.

18. Composition photopolymérisable selon une des revendications 10 à 17, **caractérisée en ce qu'** elle contient, comme auxiliaires de formulation, des solvants, antioxydants, stabilisants contre l'effet de la lumière, plastifiants, colorants, pigments, matières de charge, matières de charge pour renforçateurs, lubrifiants, tensioactifs et auxiliaires de démoulage.

19. Procédé pour la fabrication de formes, enduits, images en relief ou structures en relief par l'action du rayonnement actinique sur une composition polymérisable, selon une des revendications 10 à 18.
